(19) Europäisches Patentamt
European Patent Office
Office européen des brevets

(11) **EP 4 090 981 B1**

(12) **EUROPÄISCHE PATENTSCHRIFT**

(45) Veröffentlichungstag und Bekanntmachung des Hinweises auf die Patenterteilung:
**30.08.2023   Patentblatt 2023/35**

(21) Anmeldenummer: **21700902.6**

(22) Anmeldetag: **15.01.2021**

(51) Internationale Patentklassifikation (IPC):
*G01R 31/12* (2020.01)    *H02S 50/10* (2014.01)

(52) Gemeinsame Patentklassifikation (CPC):
**G01R 31/1227; H02S 50/10**

(86) Internationale Anmeldenummer:
**PCT/EP2021/050831**

(87) Internationale Veröffentlichungsnummer:
**WO 2021/144434 (22.07.2021 Gazette 2021/29)**

(54) **VERFAHREN UND SCHALTUNGSANORDNUNG ZUR DETEKTION EINES LICHTBOGENS UND PHOTOVOLTAIK (PV) - WECHSELRICHTER MIT EINER ENTSPRECHENDEN SCHALTUNGSANORDNUNG**

METHOD AND CIRCUIT ARRANGEMENT FOR DETECTING AN ARC, AND PHOTOVOLTAIC (PV) INVERTER HAVING A CORRESPONDING CIRCUIT ARRANGEMENT

PROCÉDÉ ET AGENCEMENT DE CIRCUIT POUR DÉTECTER UN ARC, ET ONDULEUR PHOTOVOLTAÏQUE (PV) COMPRENANT UN AGENCEMENT DE CIRCUIT CORRESPONDANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.01.2020   DE 102020100838**

(43) Veröffentlichungstag der Anmeldung:
**23.11.2022   Patentblatt 2022/47**

(73) Patentinhaber: **SMA Solar Technology AG 34266 Niestetal (DE)**

(72) Erfinder:
• **KRATOCHVIL, Marcel 34121 Kassel (DE)**
• **SCHMITT, Rainer 36088 Hünfeld (DE)**
• **PAPE, Sybille 34246 Vellmar (DE)**

(56) Entgegenhaltungen:
**WO-A1-2012/116722     US-A1- 2016 291 073**

**Beschreibung**

**Technisches Gebiet der Erfindung**

Die Erfindung betrifft ein Verfahren und eine Schaltanordnung zur Detektion eines Lichtbogens, sowie einen Photovoltaik (PV) - Wechselrichter mit einer derartigen Schaltungsanordnung.

**Stand der Technik**

Lichtbögen können in elektrischen Anlagen einen nicht unerheblichen Schaden anrichten, der beispielsweise zu einem Brand der elektrischen Anlage, wie auch eines die Anlage umfassenden Gebäudes führen kann. Auch Personenschäden sind möglich. Aus diesem Grund ist die Erkennung eines Lichtbogens bei elektrischen Anlagen eine wichtige Anforderung. Dies gilt insbesondere dann, wenn die elektrischen Anlagen einen Gleichstrom (DC) - Kreis aufweisen, da in einem DC-Kreis im Gegensatz zu einem Wechselstrom (AC) - Kreis üblicherweise kein Nulldurchgang einer elektrischen Spannung existiert, der einen brennenden Lichtbogen löschen, zumindest jedoch dessen Löschen begünstigen kann.

Üblicherweise werden zwei verschiedene Arten von Lichtbögen unterschieden. Ein Serien-Lichtbogen entsteht bei Kontaktfehlern, beispielsweise wenn Kabel oder Stecker sich lösen, die Kontakte aber so nah sind, dass in einem Zwischenraum zwischen den Kontakten lokal begrenzt eine hohe elektrische Feldstärke vorhanden ist. Ein Beispiel für einen Serien-Lichtbogen ist auch ein während eines Schaltvorganges zwischen Kontakten eines Relais auftretender Schalt-Lichtbogen. Parallele Lichtbögen sind seltener und treten beispielsweise dann auf, wenn Plus- und Minusleitungen einer elektrischen Anlage nah beieinander geführt werden und deren Isolierung schadhaft wird. Auch hier kann zwischen den beschädigten Leitern lokal begrenzt eine hohe Feldstärke vorhanden sein. Eine in einem Serien-Lichtbögen umgesetzte Verlustleistung ist üblicherweise deutlich geringer als die in einem Parallel-Lichtbogen umgesetzte Verlustleistung. Daher verursacht ein Serien-Lichtbogen zwischen einer Energiequelle und einer von der Energiequelle versorgten Last eine relativ kleine Änderung der übertragenen Leistung. Im Gegensatz dazu hat ein Parallel-Lichtbogen eine große Änderung der von der Energiequelle gelieferten und letztendlich von der Last verbrauchten elektrischen Leistung zur Folge.

Ein herkömmliches Verfahren zur Detektion eines Lichtbogens nutzt ein von dem Lichtbogen üblicherweise ausgesendetes Rausch-Spektrum. Dabei ist dann, wenn ein Lichtbogen in einer elektrischen Anlage vorliegt, einer elektrischen Nutzspannung bzw. einem elektrischen Nutzstrom eine hochfrequente Störspannung bzw. ein hochfrequenter Störstrom überlagert. Die hochfrequente Störspannung und/oder der hochfrequente Störstrom können auf den auch den Nutzstrom bzw. die Nutzspannung tragenden elektrischen Leitern elektrisch gefiltert und detektiert werden. Bei Überschreiten einer bestimmten Störspannung und oder eines bestimmten Störstroms wird ein Lichtbogen signalisiert. Ein derartiges Verfahren ist beispielsweise in der WO 2012 / 116 722 A1 beschrieben. Um eine Empfindlichkeit der Detektion zu steigern, ist auch eine gleichzeitige Detektion mehrerer unterschiedlicher Frequenzen innerhalb des ausgesendeten Rausch-Spektrums möglich.

Ein weiteres bekanntes Verfahren zur Detektion eines Lichtbogens nutzt eine mit der Entstehung des Lichtbogens einhergehende sprungartige Änderung einer elektrischen Spannung und/oder eines elektrischen Stroms. Hierbei wird ein Strom und/oder eine Spannung üblicherweise mit einer hohen Zeitauflösung auf die Erkennung einer sprunghaften Änderung hin überwacht. Bei dem Verfahren kann gegebenenfalls auch überprüft werden, inwieweit eine beobachtete Änderung des Stroms und/oder der Spannung sich von üblichen Schwankungen im Leistungsverbrauch der elektrischen Last unterscheidet. Ein Lichtbogen wird dann signalisiert, wenn sich die beobachtete Änderung des Stroms und/oder der Spannung signifikant von den üblichen Verbrauchs-Schwankungen der Anlage abgrenzt. Ein derartiges Verfahren wird zum Beispiel in der Schrift WO 2011 / 017721 A1 offenbart.

Schließlich ist aus der Schrift WO 2013 / 171329 A1 ein Verfahren zur Lichtbogendetektion bekannt, welches die Detektion eines Rauschsignales mit der Detektion einer sprungartigen Stromänderung kombiniert. Dabei ist es möglich, das zeitliche Auftreten des detektierten Rauschsignales, wie auch das zeitliche Auftreten der detektierten Stromänderung jeweils mit einem Zeitstempel zu versehen. Über einen Abgleich beider Zeitstempel kann eine zusätzliche Plausibilisierung für die Existenz eines Lichtbogens ermittelt werden.

Sämtliche Verfahren nutzen üblicherweise relativ aufwändige und daher kostenintensive Messsysteme, die umso aufwändiger werden, je sicherer ein eventuell vorhandener Lichtbogen erkannt beziehungsweise je sicherer eine Fehlsignalisierung eines Lichtbogens und eine damit verbundene Deaktivierung der elektrischen Anlage vermieden werden soll.

Aus der Schrift DE 102 25 259 B3 ist ein elektrischer Steckverbinder mit einem bei einem Aussteckvorgang voreilenden Hauptkontakt und einem dazu parallel geschalteten nacheilenden Hilfskontakt bekannt. Beim Ausstecken des Steckverbinders wird der Hauptkontakt zwangsläufig zuerst und der Hilfskontakt zuletzt von seinem Gegensteckteil getrennt. Zur Vermeidung eines mit einem Aussteckvorgang verbundenen Lichtbogens wird ein in Reihe mit dem Hilfskontakt geschalteter Halbleiterschalter zwischen einer Kontakttrennung des Hauptkontaktes und des Hilfskontaktes periodisch ein- und ausgeschaltet.

## Aufgabe der Erfindung

Der Erfindung liegt die Aufgabe zugrunde, ein Verfahren zur Detektion eines Lichtbogens, insbesondere eines Serien-Lichtbogens, in einem DC-Kreis anzugeben, das vergleichsweise kostengünstig erfolgen kann. Insbesondere sollen dabei aufwändige Detektionssysteme möglichst vermieden und stattdessen eine relativ einfach und kostengünstig ausgelegte Messtechnik verwendet werden. Es ist zudem Aufgabe der Erfindung, eine zur Durchführung des Verfahrens geeignete Schaltungsanordnung, sowie einen Photovoltaik (PV) - Wechselrichter mit einer derartigen Schaltungsanordnung anzugeben.

## Lösung

Die Aufgabe, ein Verfahren zur Lichtbogendetektion der eingangs genannten Art aufzuzeigen, wird erfindungsgemäß mit den Merkmalen des unabhängigen Patentanspruchs 1 gelöst. Die Aufgabe, eine zur Durchführung des Verfahrens geeignete Schaltungsanordnung anzugeben, wird erfindungsgemäß mit den Merkmalen des unabhängigen Anspruchs 12 gelöst. Die Aufgabe, einen PV-Wechselrichter mit einer derartigen Schaltungsanordnung aufzuzeigen, wird mit den Merkmalen des unabhängigen Anspruchs 15 gelöst. Vorteilhafte Varianten des Verfahrens sind in den abhängigen Ansprüchen 2 bis 11, vorteilhafte Ausführungsformen der Schaltungsanordnung sind in den abhängigen Ansprüchen 13 und 14, sowie vorteilhafte Ausführungsformen des PV-Wechselrichters sind in den abhängigen Ansprüchen 16 und 17 wiedergegeben.

## Beschreibung der Erfindung

Das erfindungsgemäße Verfahren zielt auf eine Detektion eines Lichtbogens in einem Gleichstrom (DC) - Kreis mit einer DC-Last, einer die DC-Last versorgenden DC-Quelle und einer zwischen der DC-Quelle und der DC-Last angeordneten Schaltungsanordnung. Dabei umfasst die Schaltungsanordnung einen Eingang mit zwei Eingangsanschlüssen zum Anschluss der DC-Quelle, einen Ausgang mit zwei Ausgangsanschlüssen zum Anschluss der DC-Last, und eine zwischen dem Eingang und dem Ausgang angeordnete Schalteinheit. Die Schalteinheit weist zumindest zwei Betriebsmodi auf und ist in diesen betreibbar. Konkret ist die Schalteinheit, gegebenenfalls in Verbindung mit einer an dem Ausgang der Schaltungsanordnung anliegenden Ausgangsspannung $U_{aus}$, in einem ersten Betriebsmodus BM1 ausgelegt, einen Leistungsfluss P zwischen der DC-Quelle und dem Ausgang der Schaltungsanordnung zu ermöglichen und in einem zweiten Betriebsmodus BM2 ausgelegt, den Leistungsfluss zwischen der DC-Quelle und dem Ausgang der Schaltungsanordnung zu unterdrücken. Das Verfahren umfasst die Verfahrensschritte:

- Zyklisches Unterbrechen des Leistungsflusses P zwischen der DC-Quelle und dem Ausgang der Schaltungsanordnung mittels der Schalteinheit, so dass der Leistungsfluss P in einem aktiven Zeitfenster mit der ersten Zeitdauer $\Delta t_1$ ermöglicht wird, dass dort also $P \neq 0$ ist, und der Leistungsfluss P in einem deaktiven Zeitfenster mit der zweiten Zeitdauer $\Delta t_2$ unterdrückt wird, dass dort also $P = 0$ ist,
- Detektion eines den Leistungsfluss P charakterisierenden Stroms I und/oder einer den Leistungsfluss P charakterisierenden Spannung U in zwei aufeinanderfolgenden aktiven Zeitfenstern,
- Vergleich der detektierten Werte von Strom I und/oder Spannung U eines aktiven Zeitfensters mit den korrespondierenden detektierten Werten aus dem vorangegangenen aktiven Zeitfenster, und
- Signalisierung eines Lichtbogens, wenn sich die Werte von Strom I und/oder Spannung U des aktiven Zeitfensters von den korrespondierenden Werten des vorangegangenen aktiven Zeitfensters um mehr als einen Schwellwert unterscheiden.

Bei dem zu detektierenden Lichtbogen kann es sich insbesondere um einen seriellen Lichtbogen handeln. Die Schaltungsanordnung kann ganz oder teilweise Bestandteil eines elektrischen Gerätes, beispielsweise einer Energieumwandlungseinheit, z. B. eines Wechselrichters sein. Die DC-Last kann als eine DC-Last im herkömmlichen Sinne ausgebildet sein und hierzu ausschließlich DC-Verbraucher beinhalten. Sie kann jedoch auch einen DC/AC-Wandler umfassen, der ausgangsseitig mit einer Wechselspannungs (AC) - Last verbunden ist. Die AC-Last kann ein elektrisches Gerät sein, welches durch eine Wechselspannung versorgt wird. Alternativ dazu kann die AC-Last jedoch auch ein Energieversorgungsnetz sein, in das der DC/AC-Wandler eine aus einer DC-Leistung umgewandelte AC-Leistung einspeist. Mit einem zyklischen Unterbrechen des Leistungsflusses P ist ein einer Regel genügendes wiederholtes Unterbrechen des Leistungsflusses P gemeint, welches periodisch erfolgen kann, aber nicht periodisch erfolgen muss. Bei einem periodisch erfolgenden Unterbrechen ist eine Summe der ersten Zeitdauer $\Delta t_1$ und der zweiten Zeitdauer $\Delta t_2$ konstant, d.h. $\Delta t_1 + \Delta t_2 = const$, während die Summe bei einem aperiodisch erfolgenden Unterbrechen gerade nicht konstant ist. Ein periodisches Unterbrechen des Leistungsflusses P kann dann erfolgen, wenn eine Leistungsschwankung im Verbrauch der DC-Last als vernachlässigbar gering eingestuft werden kann. Sofern das nicht vorausgesetzt werden kann, erfolgt das zyklische Unterbrechen des Leistungsflusses üblicherweise aperiodisch. Bei dem zu detektierenden, den Leistungsfluss P charakterisierenden Strom I kann es sich um einen zwischen der DC-Quelle und dem Eingang der Schaltungsanordnung fließenden Strom handeln. Alternativ dazu kann es sich auch um einen zwischen dem Eingang der Schaltungsanordnung und der Schalteinheit oder um einen zwischen der Schalteinheit und dem Ausgang der Schaltungsanordnung fließenden Strom handeln. Bei der detektierten Spannung U kann es sich um eine am Eingang der Schaltungsanordnung anliegende Spannung und/oder um eine am Ausgang der Schaltungsanordnung anliegende Spannung handeln. Es liegt im Rahmen der Erfindung lediglich einen Strom, alternativ aber auch mehrere den Leistungsfluss P zwischen der DC-Quelle und dem Ausgang charakterisierenden Ströme zu detektieren. Alternativ oder kumulativ dazu ist es möglich, lediglich eine Spannung gegebenenfalls aber auch mehrere den Leistungsfluss P zwischen der DC-Quelle und dem Ausgang der Schaltungsanordnung charakterisierende Spannungen zu detektieren.

Die Erfindung nutzt den Effekt, dass ein in dem DC-Kreis zwischen der DC-Quelle und der DC-Last üblicherweise kontinuierlich erfolgender Leistungsfluss P durch die Schalteinheit in einen diskontinuierlich erfolgenden Leistungsfluss P gewandelt wird. Dies gilt zumindest für einen ersten Bereich des DC-Kreises, der zwischen der DC-Quelle und dem Ausgang der Schaltungsanordnung angeordnet ist. Dabei ist es zwar möglich, aber nicht zwingend erforderlich, dass der Leistungsfluss P überall in dem ersten Bereich des DC-Kreises - also auf der gesamten Strecke zwischen der DC-Quelle und dem Ausgang der Schaltanordnung - unterbrochen wird. Vielmehr ist es ausreichend, wenn das zyklische Unterbrechen des Leistungsflusses lediglich auf einer Teilstrecke zwischen der DC-Quelle und dem Ausgang der Schaltungsanordnung erfolgt. Konkret können beispielsweise dann, wenn der Leistungsfluss lediglich auf einer Teilstrecke zwischen der DC-Quelle und dem Ausgang unterbrochen ist, in der restlichen Teilstrecke des ersten Bereiches des DC-Kreises noch abklingende Aufladevorgänge von dort vorhandenen Kapazitäten erfolgen. Indem jedoch der Leistungsfluss auf einer Teilstrecke des ersten Bereiches des DC-Kreises unterdrückt wird, wird in Reaktion darauf der Leistungsfluss auf der restlichen Teilstrecke innerhalb des ersten Bereiches des DC-Kreises zumindest weitgehend reduziert. In einem zweiten Bereich des DC-Kreises, der zwischen dem Ausgang der Schaltungsanordnung und der DC-Last angeordnet ist, kann der Leistungsfluss entweder diskontinuierlich oder kontinuierlich erfolgen.

Indem in den deaktivierten zweiten Zeitfenstern kein Leistungsfluss von der DC-Quelle zu dem Ausgang der Schaltungsanordnung erfolgt, wird ein Nulldurchgang eines Stroms I in dem DC-Kreis, zumindest jedoch in dem ersten Bereich des DC-Kreises, und dort zumindest auf einer Teilstrecke des sich von der DC-Quelle zu dem Ausgang der Schaltanordnung erstreckenden ersten Bereiches des DC-Kreises bewusst herbeigeführt. Zusammenfassend gilt für den gesamten ersten Bereich des DC-Kreises zwischen der DC-Quelle und dem Ausgang der Schaltungsanordnung, dass der Leistungsfluss P, sofern er dort nicht überall vollständig unterbrochen ist, zumindest dort überall weitgehend reduziert ist. Dabei wird auch gleichzeitig einem in dem ersten Bereich des DC-Kreises eventuell vorhandenen seriellen Lichtbogen die Energie entzogen. Durch den Energieentzug kann der Lichtbogen nicht weiter brennen, sondern wird, zumindest temporär innerhalb des deaktiven Zeitfensters, gelöscht. Wenn nun in einem auf das deaktive Zeitfenster folgenden aktiven Zeitfenster wieder ein Leistungsfluss P von der DC-Quelle zu dem Ausgang der Schaltungsanordnung erfolgt, so ist ein Risiko, dass dieser Leistungsfluss P ebenfalls mit einem brennenden Lichtbogen einhergeht, relativ zu dem vorherigen aktiven Zeitfenster, in dem der Lichtbogen noch brannte, signifikant reduziert. Mit anderen Worten: wenn in dem zeitlich vorangehenden der beiden aktiven Zeitfenster ein Lichtbogen brannte, so ist der Lichtbogen in dem zeitlich nachfolgenden der beiden aktiven Zeitfenster mit hoher Wahrscheinlichkeit nicht mehr vorhanden. Dabei steigt die Wahrscheinlichkeit mit zunehmender zweiter Zeitdauer des deaktiven Zeitfensters oder der deaktiven Zeitfenster, die zwischen den zwei aktiven Zeitfenstern liegen.

Erfindungsgemäß werden in jedem der beiden zeitlich versetzten aktiven Zeitfenster jeweils ein Strom I und/oder eine Spannung U detektiert, die dem Leistungsfluss P in dem jeweiligen aktiven Zeitfenster zugeordnet sind. Da einem Lichtbogen auch eine von dem Lichtbogen verbrauchte Verlustleistung zugeordnet werden kann, ändern sich die elektrischen Größen von Strom I und/oder Spannung U abhängig von der Existenz des Lichtbogens in dem DC-Kreis. Daher kann aus einem Vergleich der detektierten Werte von Strom I und/oder Spannung U der beiden zeitlich versetzten aktiven Zeitfenster darauf geschlossen werden, ob eines der beiden aktiven Zeitfenster im Gegensatz zu dem jeweils anderen der beiden aktiven Zeitfenster einen Lichtbogen aufweist oder nicht. Dies gilt insbesondere dann, wenn der zeitliche Verbrauch der DC-Last aus anderen Gründen bekannt ist und/oder sich zeitlich nicht, zumindest nicht signifikant ändert. Konkret kann somit ein Lichtbogen dann signalisiert werden, wenn sich die Werte von Strom I und/oder Spannung U des zeitlich nachfolgenden aktiven Zeitfensters um mehr als einen vordefinierten Schwellwert von den korrespondierenden Werten von Strom I und/oder Spannung des nachfolgenden aktiven Zeitfensters unterscheiden.

Bei dem erfindungsgemäßen Verfahren sind keine gesonderten Anforderungen an eine Messeinheit zur Detektion der elektrischen Größen aus Strom I und/oder Spannung U zu stellen. Weder muss die Messeinheit eine hohe Genauigkeit noch eine hohe zeitliche Auflösung, also eine hohe Messfrequenz aufweisen. Es kommt nämlich nicht darauf an, eine sprungartige Änderung der elektrischen Größen zu detektieren. Vielmehr ist es ausreichend, lediglich einen für das jeweilige aktive Zeitfenster repräsentativen Wert der elektrischen Größen, beispielsweise einen Mittelwert des jeweiligen aktiven Zeitfensters, zu detektieren. Aus diesem Grund kann die Messeinheit zur Detektion der elektrischen Größen sehr kostengünstig ausgebildet sein. Oftmals ist sie ohnehin schon in dem DC-Kreis vorhanden, weswegen in diesem Fall keine Zusatzkosten anfallen. Da erfindungsgemäß der Leistungsfluss P in dem DC-Kreis zwischen der DC-Quelle und dem Ausgang der Schaltungsanordnung auch im normalen Betrieb der DC-Last diskontinuierlich, quasi in einzelnen Energiepaketen erfolgt, ist eine aufwändige Detektionseinheit zum Auslösen einer ansonsten einmaligen Unterbrechung eines kontinuierlich erfolgenden Leistungsflusses nicht erforderlich. Vielmehr operiert das erfindungsgemäße Verfahren so, als wäre zumindest in dem ersten Bereich des DC-Kreises in jedem der aktiven Zeitfenster ein Lichtbogen, insbesondere ein serieller Lichtbogen vorhanden, der durch die mittels der Schalteinheit erzeugte Unterbrechung des von der DC-Quelle ausgehenden Leistungsflusses P in dem deaktiven Zeitfenster gelöscht werden müsste. Die Information, ob auch tatsächlich ein Lichtbogen in dem vorangegangenen aktiven Zeitfenster vorhanden war, ergibt sich erst aus der Detektion der elektrischen Größen von Strom I und/oder Spannung U in dem zeitlich nachfolgenden aktiven Zeitfenster und dem Vergleich derselben mit den korrespondierenden detektierten Größen von Strom I und/oder Spannung U des zeitlich vorangegangenen aktiven Zeitfensters.

In den deaktiven Zeitfenstern kann sich die DC-Last aus einem ohnehin an einem Eingang der DC Last vorhandenen Energiezwischenspeicher, z.B. einer Kapazität oder aus einer zusätzlich vorzusehenden und parallel zu dem Ausgang der Schaltungsanordnung verschalteten Kapazität versorgen. Zusätzlich können die zweiten Zeitdauern $\Delta t_2$ der deaktiven Zeitfenster so gering gewählt werden, dass sich die Kapazität nur unwesentlich entlädt, so dass eine Unterversorgung der DC-Last und ein damit eventuell verbundener fehlerhafter Betrieb der DC-Last weitestgehend vermieden werden kann.

In einer vorteilhaften Ausführungsform des Verfahrens kann die Schalteinheit, gegebenenfalls in Verbindung mit einer an dem Ausgang der Schaltungsanordnung anliegenden Ausgangsspannung $U_{aus}$, den Leistungsfluss P zwischen der DC-Quelle und dem Ausgang der Schaltungsanordnung in Reaktion auf einen signalisierten Lichtbogen dauerhaft unterbrechen, zumindest jedoch für einen Zeitraum, der groß gegen die zweite Zeitdauer $\Delta t_2$ des deaktiven Zeitfensters ist. Beispielsweise kann eine derartige in Reaktion auf einen signalisierten Lichtbogen erfolgende Unterbrechung für einige Minuten oder solange andauern, bis sie manuell quittiert wird. Auf diese Weise kann einer Fachkraft die Möglichkeit gegeben werden, eventuelle durch den detektierten Lichtbogen hervorgerufene Schäden in dem DC-Kreis zu erkennen und zu reparieren.

Das aktive Zeitfenster und das vorangegangene aktive Zeitfenster, dessen Werte von Strom I und/oder Spannung U miteinander verglichen werden, müssen nicht zwingend direkt aufeinanderfolgen. Vielmehr können sie durch mehrere deaktive Zeitfenster und zumindest ein weiteres aktives Zeitfenster voneinander getrennt sein. In einer vorteilhaften Ausführungsform des Verfahrens kann jedoch das aktive Zeitfenster und das vorangegangene aktive Zeitfenster auch durch genau ein deaktives Zeitfenster voneinander getrennt sein. Auf diese Weise fällt eine zwischenzeitlich erfolgende Änderung im Verbrauch der DC-Last bei dem Vergleich der elektrischen Größen weniger stark ins Gewicht.

In einer vorteilhaften Ausführungsform des Verfahrens kann ein Wert der zweiten Zeitdauer $\Delta t_2$ der deaktiven Zeitfenster so gewählt sein, dass er nicht nur ausreichend hoch ist, einen in dem DC-Kreis gegebenenfalls vorhandenen Lichtbogen zu löschen, sondern vielmehr auch ausreichend hoch ist, um eine erneute Zündung des zuvor gelöschten Lichtbogen in einem dem deaktiven Zeitfenster zeitlich nachfolgenden aktiven Zeitfenster zu unterdrücken. Der Wert der zweiten Zeitdauer kann insbesondere von einer dem Lichtbogen zugeordneten thermischen Zeitkonstante abhängen und dabei insbesondere größer als die entsprechende thermische Zeitkonstante sein. Die thermische Zeitkonstante beschreibt eine zeitliche Abnahme der elektrischen Leitfähigkeit der als Plasma ausgebildeten Lichtbogensäule für den Fall, dass dem Lichtbogen keine elektrische Energie mehr zugeführt wird, beispielsweise weil der Leistungsfluss in dem ersten Bereich des DC-Kreis mittels der Schalteinheit unterbrochen wurde. Konkret kann dann, wenn nach einer Löschung eines Lichtbogens eine Zeit für das erneute Anlegen einer elektrischen Spannung U an die Lichtbogensäule größer als die thermische Zeitkonstante ist, kein erneutes Zünden des Lichtbogens erfolgen. Zudem kann ein Wert der minimal notwendigen Unterbrechungszeit des Stromflusses auch von der in dem brennenden Lichtbogen umgesetzten Leistung abhängen. Daher kann ein Wert der zweiten Zeitdauer $\Delta t_2$ des deaktiven Zeitfensters auch in Abhängigkeit der detektierten Werte von Strom I und/oder Spannung U des unmittelbar vorangegangenen aktiven Zeitfensters gewählt werden. Insbesondere kann dabei der Wert der zweiten Zeitdauer $\Delta t_2$ mit steigendem Wert des detektierten Stroms I und/oder der detektierten Spannung U aus dem vorangegangenen Zeitfenster ansteigen. In Versuchen zeigt sich, dass es ausreichend ist, wenn die zweite Zeitdauer $\Delta t_2$ einen Wert zwischen 0,1 ms und 10,0 ms, vorzugsweise einen Wert zwischen 0,3 ms und 4,0 ms aufweist.

In einer Variante des Verfahrens wird der Leistungsfluss P zwischen dem Eingang und dem Ausgang der Schaltungsanordnung mittels der Schalteinheit unterbrochen. Die Schaltungsanordnung kann eine parallel zu ihrem Eingang verschaltete Eingangskapazität aufweisen. Dabei kann vorteilhafterweise zusätzlich in dem deaktiven Zeitfenster ein an dem Eingang fließender Eingangsstrom $I_{ein}$ und/oder eine an dem Eingang zwischen den Eingangsanschlüssen anliegende Eingangsspannung $D_{ein}$ detektiert werden. Die zweite Zeitdauer $\Delta t_2$ des deaktiven Zeitfensters kann nun in Abhängigkeit von dem detektierten Eingangsstrom $I_{ein}$ und/oder der detektierten Eingangsspannung $D_{ein}$ bestimmt werden. Konkret kann beispielsweise die zweite Zeitdauer $\Delta t_2$ des deak-

tiven Zeitfensters dadurch begrenzt werden, dass der in dem deaktiven Zeitfenster detektierte Eingangsstrom $I_{ein}$ einen weiteren Stromschwellwert $I_{TH2}$ unterschreitet, ab dem keine nennenswerte Aufladung der Eingangskapazität mehr erfolgt. Dies kann beispielsweise am zeitlichen Verlauf der an der Eingangskapazität - und somit auch am Eingang der Schaltungsanordnung - anliegenden Eingangsspannung $U_{ein}$ festgestellt werden. Zusätzlich ist der weitere Stromschwellwert $I_{TH2}$ so gewählt, insbesondere so niedrig gewählt, dass ein serieller Lichtbogen, sofern er zwischen der DC-Quelle und dem Eingang der Schaltungsanordnung vorhanden sein sollte, nicht weiter brennen kann. Dies kann beispielsweise empirisch ermittelt bzw. verifiziert werden. Somit ist mit dem Unterschreiten des weiteren Stromschwellwertes $I_{TH2}$ sichergestellt, dass ein zwischen der DC-Quelle und dem Eingang der Schaltungsanordnung gegebenenfalls vorhandener serieller Lichtbogen sicher gelöscht ist.

Es ist selbstverständlich, dass der an dem Eingang der Schaltungsanordnung fließende Eingangsstrom $I_{ein}$ über einen entsprechenden Stromsensor detektiert werden kann. Dies erfordert jedoch zusätzlich zu einem dort oftmals ohnehin vorhandenen Spannungssensor das Vorhalten eines zusätzlichen Stromsensors. In einer Ausführungsform des Verfahrens, bei der die Schaltungsanordnung eine parallel zu ihrem Eingang verschaltete Eingangskapazität aufweist, und bei der der Leistungsfluss P zwischen dem Eingang und dem Ausgang unterbrochen wird, kann der zwischen der DC-Quelle und dem Eingang der Schaltungsanordnung fließende Strom zumindest teilweise, gegebenenfalls auch größtenteils oder vollständig durch den an dem Eingang fließenden Eingangsstrom $I_{ein}$ gebildet werden. Hierbei kann nun in dem deaktiven Zeitfenster der an dem Eingang fließende, insbesondere der in die Eingangskapazität fließende Eingangsstrom $I_{ein}$ auch über eine zeitliche Änderung der an der Eingangskapazität anliegenden Eingangsspannung $U_{ein}$ gemessen werden. Konkret liefert hier die zeitliche Ableitung der über der Eingangskapazität anliegenden Eingangsspannung $U_{ein}$, die auch zwischen den Eingangsanschlüssen anliegt, ein Maß für den zwischen der DC-Quelle und dem Eingang der Schaltungsanordnung fließenden Strom. Auf diese Weise ist es möglich, mit lediglich einem Spannungssensor sowohl die an dem Eingang zwischen den Eingangsanschlüssen anliegende Eingangsspannung $D_{ein}$ als auch den an dem Eingang fließenden Eingangsstrom $I_{ein}$ zu bestimmen.

In einer weiteren Variante des Verfahrens wird die Schalteinheit der Schaltungsanordnung durch einen DC/DC-Wandler, insbesondere einen Hochsetzsteller gebildet. Zusätzlich weist die Schaltungsanordnung eine parallel mit ihrem Ausgang verbundene Ausgangskapazität auf. Vorteilhafterweise kann dabei in dem aktiven Zeitfenster eine an der Ausgangskapazität anliegende Spannung $U_{aus}$ zu einem Ende der ersten Zeitdauer $\Delta t_1$ hin durch die Schalteinheit vergrößert werden. Beispielsweise kann bei Erreichen oder Überschreiten von zumindest 50%, bevorzugt von zumindest 75%, besonders bevorzugt von zumindest 90% der ersten Zeitdauer $\Delta t_1$ des aktiven Zeitfensters die an der Ausgangskapazität anliegenden Spannung $U_{aus}$ vergrößert werden. Dabei kann die Vergrößerung um zumindest 10%, bevorzugterweise um zumindest 20% einer bei Beginn des aktiven Zeitfensters an der Ausgangskapazität anliegenden Spannung $U_{aus}$ erfolgen. In jedem Fall sollte bei einem DC/DC-Wandler mit Freilaufdiode, der als Hochsetzsteller ausgebildet ist, die an der Ausgangskapazität anliegende Spannung $U_{aus}$ zumindest den Wert der Leerlaufspannung der DC-Quelle betragen oder übersteigen. Nur so ist sichergestellt, dass die Schalteinheit in Verbindung mit der der ausgangsseitig anliegenden Spannung $U_{aus}$ den Leistungsfluss zwischen dem Eingang und dem Ausgang der Schaltungsanordnung unterdrückt. Zusätzlich kann auf diese Weise eine Energie, die in der Ausgangskapazität zwischengespeichert wird und aus der die DC-Last insbesondere auch in dem unmittelbar angrenzenden deaktiven Zeitfenster versorgt wird, gesteigert werden. Eine Obergrenze für die zweite Zeitdauer $\Delta t_2$ für das unmittelbar angrenzende deaktive Zeitfenster kann vergrößert werden und ein Risiko einer nicht korrekten Versorgung der DC-Last insbesondere während des deaktiven Zeitfensters kann vermieden, zumindest jedoch reduziert werden. Die zur Zwischenspeicherung der Energie anfallenden Verluste des DC/DC-Wandlers treten hingegen nur zu Ende des aktiven Zeitfensters, also nur während eines Bruchteils der ersten Zeitdauer $\Delta t_1$, und nicht während des gesamten ersten Zeitfensters auf. Zusätzlich werden die die Ausgangskapazität bereitstellenden Bauteile nur über einen Bruchteil der ersten Zeitdauer mit hohen Spannungswerten belastet.

In einer Ausführungsform des Verfahrens kann ein Wert der ersten Zeitdauer $\Delta t_1$ des aktiven Zeitfenster so gewählt werden, dass eine Lichtbogenenergie, die über eine Verlustleistung eines in dem aktiven Zeitfenster angenommenen Lichtbogen erzeugt würde, einen vorgegebenen maximal erlaubten Energiewert $E_{max}$ nicht überschreitet. In diesem Fall wird also in dem aktuellen aktiven Zeitfenster von einem fiktiv - real jedoch nicht zwingend vorhandenen - Lichtbogen ausgegangen. Basierend auf der Annahme des in dem aktiven Zeitfenster brennenden fiktiven Lichtbogens lässt sich jedoch über den Strom I in dem aktiven Zeitfenster und einen angenommenen Spannungsabfall $\Delta U_{LB}$ des Lichtbogens die erste Zeitdauer $\Delta t_1$ des aktuellen aktiven Zeitfensters gemäß

$$\Delta t_1 = \frac{E_{max}}{\Delta U_{LB} * I}$$

abschätzen. Je nach zeitlichem Auflösungsvermögen der vorliegenden Messeinheit können auch mehrere detektierte Werte für den Strom I verwendet werden. In diesem Fall kann in dem Nenner der oben angegebenen Gleichung für den Strom I ein gemittelter Strom $I_{Mittelwert}$

eingesetzt werden. Für den Spannungsabfall $\Delta U_{LB}$ des Lichtbogens existieren experimentell ermittelte oder erfahrungsbasierte Werte. Beispielsweise kann bei gebräuchlichen PV-Anlagen für den Spannungsabfall des Lichtbogens in guter Näherung ein Wert zwischen 30 V und 40 V angesetzt werden.

Im Hinblick auf eine Detektion eines Lichtbogens in einem DC-Kreis einer Photovoltaik (PV) - Anlage ist es vorteilhaft, wenn der maximal mögliche Energiewert $E_{max}$ einen auch in einschlägigen Normen aufgeführten Wert von $E_{max}$ = 200 J aufweist. Konkret kann dann, wenn die in dem aktiven Zeitfenster transportierte Energiemenge den Wert 200 J nicht überschreitet, für den Fall, dass tatsächlich ein Lichtbogen in dem vorangegangenen aktiven Zeitfenster detektiert wurde, ein Wiederanfahren der PV-Anlage in vereinfachter Form und insbesondere ohne Hinzuziehen einer elektrischen Fachkraft durchgeführt werden.

In einer Ausführungsform des Verfahrens können mehrere DC-Quellen über jeweils eine Schaltungsanordnung parallel zueinander mit der DC-Last verbunden sein, um mit ihren jeweiligen Leistungsflüssen P die DC-Last gemeinsam zu versorgen. Dabei kann das Verfahren zur Detektion eines insbesondere Serien-Lichtbogens für jede der DC-Quellen gleichzeitig durchgeführt werden, wobei die dem jeweiligen zyklischen Unterbrechen des Leistungsflusses P zugeordneten deaktiven Zeitfenster bei der Durchführung des Verfahrens für die unterschiedlichen DC-Quellen möglichst zeitlich versetzt zueinander angeordnet sind und sich möglichst nicht überlappen. Vorteilhafterweise erfolgt das zyklische Unterbrechen der Leistungsflüsse P derart, dass zumindest ein zeitlicher Überlapp zwischen den deaktiven Zeitfenstern der unterschiedlichen DC-Quellen minimiert wird. Auf diese Weise ist ein robuster Betrieb der DC-Last dadurch gewährleistet, dass eine Schwankung des totalen Leistungsflusses, der sich aus einer Summe der einzelnen Leistungsflüsse P der mehreren DC-Quellen ergibt, minimiert ist.

Eine erfindungsgemäße Schaltungsanordnung zur Detektion eines Lichtbogens in einem DC-Kreis umfasst:

- einen Eingang mit zwei Eingangsanschlüssen zum Anschluss einer DC-Quelle, und einen Ausgang mit zwei Ausgangsanschlüssen zum Anschluss einer DC-Last,
- eine zwischen dem Eingang und dem Ausgang angeordnete Schalteinheit, wobei die Schalteinheit, gegebenenfalls in Verbindung mit einer an dem Ausgang der Schaltungsanordnung anliegenden Ausgangsspannung $U_{aus}$, ausgelegt und eingerichtet ist, in einem ersten Betriebsmodus BM1 einen Leistungsflusses P zwischen dem Eingang und dem Ausgang zu ermöglichen und in einem zweiten Betriebsmodus BM2 einen Leistungsflusses P zwischen dem Eingang und dem Ausgang zu unterdrücken,

- eine Messeinheit zur Bestimmung einer an dem Eingang oder an dem Ausgang anliegenden Spannung U und/oder eines in einer Verbindungsleitung von einem der Eingangsanschlüsse zu einem der Ausgangsanschlüsse fließenden Stroms I, und
- eine Steuerungseinheit zur Steuerung der Schalteinheit und gegebenenfalls der Messeinheit.

Die Schaltungsanordnung ist dadurch gekennzeichnet, dass die Steuerungseinheit in Verbindung mit der Schalteinheit und der Messeinheit zur Durchführung des erfindungsgemäßen Verfahrens ausgelegt und eingerichtet ist.

Damit die Schalteinheit in die Lage versetzt wird, den Leistungsfluss P zwischen dem Eingang und dem Ausgang zu unterdrücken, kann sie einen oder mehrere ansteuerbare Schalter, insbesondere Halbleiterschalter aufweisen. Alternativ oder kumulativ ist es auch möglich, dass die Schalteinheit zur Unterdrückung des Leistungsflusses P einen oder mehrere nicht ansteuerbare Halbleiterschalter, beispielsweise Dioden, aufweist. Die Steuerungseinheit kann als separate Steuerungseinheit ausgebildet sein. Alternativ kann die Steuerungseinheit aber auch als Bestandteil einer ohnehin in dem DC-Kreis vorhandenen Steuerungseinheit ausgebildet sein. Es ergeben sich die bereits in Verbindung mit dem Verfahren erläuterten Vorteile.

In einer vorteilhaften Ausführungsform der Schaltungsanordnung kann die Schalteinheit einen in einer der Verbindungsleitungen von einem der Eingangsanschlüsse zu einem der Ausgangsanschlüsse angeordneten Halbleiterschalter aufweisen. Der Halbleiterschalter kann frei von einer intrinsisch ausgebildeten oder einer separat ausgebildeten und parallel zu stromtragenden Anschlüssen des Halbleiterschalters angeschlossene Freilaufdiode sein. Alternativ dazu kann der Halbleiterschalter aber auch eine parallel zu stromtragenden Anschlüssen des Halbleiterschalters angeschlossene Freilaufdiode aufweisen. Dabei kann die Freilaufdiode entweder als intrinsische oder als separat ausgebildete Freilaufdiode ausgebildet sein. Sofern der Halbleiterschalter eine Freilaufdiode aufweist, kann sie insbesondere so angeordnet sein, dass sie in Bezug auf eine normale Stromrichtung des DC-Kreises in Sperrrichtung gepolt ist.

Die Schaltungsanordnung kann einen parallel zu dem Ausgang geschalteten Energiezwischenspeicher, insbesondere eine Kapazität aufweisen. Mit der Kapazität ist die Schaltungsanordnung in der Lage, eine begrenzte Energiemenge der DC-Quelle in dem aktiven Zeitfenster zwischenzuspeichern, mittels der die DC-Last in dem nachfolgenden deaktiven Zeitfenster versorgt wird. Auf diese Weise ist eine Versorgung der DC-Last während des deaktiven Zeitfensters selbst dann möglich, wenn die DC-Last keine Möglichkeit der Zwischenspeicherung umfasst. In diesem Fall erfolgt der Leistungsfluss P nur in dem ersten Bereich des DC-Kreises diskontinuierlich, während er in dem zweiten Bereich des DC-Kreises kontinuierlich erfolgt. Gemäß einer Ausführungsform kann die erfindungsgemäße Schaltungsanordnung oder die Schalteinheit der Schaltungsanordnung als ein DC/DC-Wandler, insbesondere als ein Hochsetzsteller ausgelegt sein. Dabei kann der Leistungsfluss P von der DC-Quelle zu dem Ausgang der Schaltungsanordnung dadurch unterbrochen werden, dass die Schaltungsanordnung, insbesondere die Schalteinheit der Schaltungsanordnung deaktiviert wird und eine an dem Ausgang der Schaltungsanordnung anliegende Spannung größer als eine an dem Eingang der Schaltungsanordnung anliegende Spannung ist. Versuche zeigen, dass eine Deaktivierung über einige wenige, vorteilhafterweise maximal 8 Schaltzyklen des DC/DC-Wandlers ausreichen.

Ein erfindungsgemäßer Photovoltaik (PV) - Wechselrichter umfasst zumindest einen Eingang mit zwei Eingangsanschlüssen zum Anschluss eines PV-Strings als DC-Quelle und einen Ausgang zum Anschluss eines Wechselspannungs (AC) - Netzes, einen DC/AC-Wandler zur Wandlung einer Gleichspannung in eine Wechselspannung, und eine erfindungsgemäße Schaltungsanordnung. Dabei ist der Eingang der Schaltungsanordnung mit dem zumindest einen Eingang des PV-Wechselrichters und der Ausgang der Schaltungsanordnung mit einem Eingang des DC/AC-Wandlers verbunden. Bei dem Wechselrichter kann es sich um einen einphasig ausgebildeten PV-Wechselrichter handeln, der ausgangsseitig maximal einen Phasenleiteranschluss und einen Neutralleiteranschluss aufweist. Alternativ kann es sich auch um einen mehrphasig ausgebildeten PV-Wechselrichter mit mehreren ausgangsseitigen, insbesondere drei ausgangsseitigen Phasenanschlüssen und einem ausgangsseitigen Neutralleiteranschluss handeln. Die Steuerungseinheit der Schaltungsanordnung kann in eine Steuerungseinheit des PV-Wechselrichters, oder in eine übergeordnete Steuerungseinheit einer den PV-Wechselrichter umfassenden PV-Anlage integriert sein. Es ergeben sich die schon in Verbindung mit dem Verfahren und der Schaltungsanordnung erwähnten Vorteile.

Wenn das erfindungsgemäße Verfahren zur Detektion eines Lichtbogens, insbesondere eines Serien-Lichtbogens, innerhalb einer PV-Anlage angewendet wird, bei der die DC-Quelle durch einen PV-String und die DC-Last einen einphasigen, ausgangsseitig mit einem Wechselspannungs (AC) - Netz verbundenen DC/AC-Wandler umfasst, ist es vorteilhaft, wenn das zyklische Unterbrechen des Leistungsflusses P derart erfolgt, dass ein Nulldurchgang eines über einen Ausgang des DC/AC-Wandlers fließenden AC-Stroms $I_{AC}$ (t) während der zweiten Zeitdauer $\Delta t_2$ des deaktiven Zeitfensters erfolgt. Bei einem einphasigen DC/AC-Wandler erfolgt nämlich eine Leistungsentnahme aus einem Zwischenspeicher des PV-Wechselrichters, beispielsweise einer Zwischenkreis-Kapazität eines DC-Zwischenkreises, sinusförmig gepulst mit einer Frequenz, die der doppelten Frequenz des an den PV-Wechselrichter angeschlossenen AC-Netzes entspricht, wobei in der Umgebung der Nulldurchgänge des von dem DC/AC-Wandler erzeugten AC-Stroms $I_{AC}$ (t) die geringste Leistungs- bzw. Energieentnahme aus dem Zwischenspeicher erfolgt. Wenn die deaktiven Zeitfenster nun zeitlich mit den Nulldurchgängen des AC-Stroms $I_{AC}$ (t) überlappen, kann ein Spannungs-Rippel des DC-Zwischenkreises minimiert werden.

In einer Ausführungsform der Erfindung kann der PV-Wechselrichter lediglich einen Eingang aufweisen, an den ein PV-String als DC-Quelle angeschlossen wird. In einer weiteren Ausführungsform der Erfindung kann der PV - Wechselrichter jedoch auch eine Mehrzahl von Eingängen aufweisen, die zum Anschluss jeweils eines PV-Strings als DC-Quelle ausgelegt sind. Dabei können die Eingänge jeweils über einen DC/DC-Wandler parallel zueinander mit einem gemeinsamen DC-Zwischenkreis verbunden sein. Der DC-Zwischenkreis, der eine Zwischenkreis-Kapazität umfassen kann, kann wiederum mit einem Eingang des DC/AC-Wandlers verbunden sein. Dabei kann jedem der Eingänge des PV-Wechselrichters eine erfindungsgemäße Schaltungsanordnung zugeordnet sein, wobei jeder der Eingänge des PV-Wechselrichters jeweils mit dem Eingang einer ihm zugeordneten Schaltungsanordnung verbunden ist und der Ausgang jeder der Schaltungsanordnungen jeweils mit dem Eingang des DC/AC-Wandlers verbunden ist. Es liegt im Rahmen der Erfindung, wenn jede der Schaltungsanordnungen zumindest teilweise, gegebenenfalls auch vollständig durch jeweils einen der DC/DC-Wandler gebildet wird.

In einer Ausführungsform des PV - Wechselrichter können die Steuerungseinheiten der Schaltungsanordnungen in einer übergeordneten Steuerungseinheit des PV-Wechselrichters beinhaltet sein. Dabei ist die übergeordnete Steuerungseinheit gleichzeitig eingerichtet, den DC/AC-Wandler und die DC/DC-Wandler des PV-Wechselrichters derart zu steuern, dass im Betrieb des PV-Wechselrichters eine an dem DC-Zwischenkreis anliegende Spannung oberhalb eines Maximalwertes der Leerlaufspannungen der einzelnen PV-Strings gehalten wird.

Vorteilhafte Ausgestaltungen der Erfindung sind in der nachfolgenden Beschreibung und den Unteransprüchen angegeben, deren Merkmale einzeln und in beliebiger Kombination miteinander angewendet werden können.

## Kurzbeschreibung der Figuren

Im Folgenden wird die Erfindung mithilfe von Figuren dargestellt. Von diesen zeigen

Fig. 1      einen DC-Kreis mit einer DC-Quelle, einer DC-Last und einer erfindungsgemäßen Schaltungsanordnung in einer ersten Ausführungsform;

**Fig. 2**　　eine erfindungsgemäße Schaltungsanordnung in einer zweiten Ausführungsform;

**Fig. 3**　　Zeitverläufe für Betriebsmodus, Strom und Spannung der Schaltungsanordnung aus Fig. 2 während des erfindungsgemäßen Verfahrens; und

**Fig. 4**　　eine PV-Anlage mit einem erfindungsgemäßen PV-Wechselrichter in einer Ausführungsform.

## Figurenbeschreibung

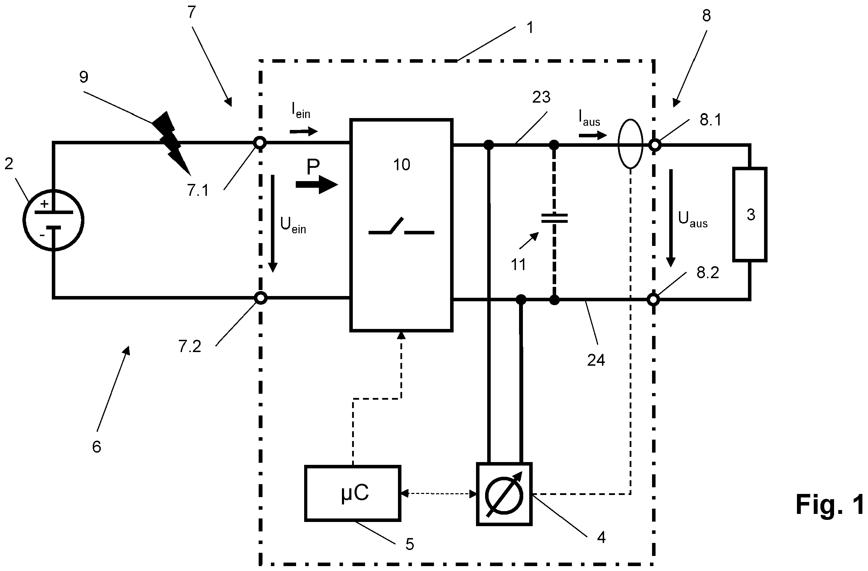

In **Fig. 1** ist ein Gleichstrom (DC)-Kreis 6 mit einer DC-Quelle 2, einer DC-Last 3 und einer erfindungsgemäßen Schaltungsanordnung 1 in einer ersten Ausführungsform dargestellt. Die DC-Quelle 2 kann einen Innenwiderstand (in Fig. 1 nicht explizit dargestellt) aufweisen. Die Schaltungsanordnung 1 weist einen Eingang 7 mit einem ersten Eingangsanschluss 7.1 und einem zweiten Eingangsanschluss 7.2 auf, an den die DC-Quelle 2 angeschlossen ist. Die Schaltungsanordnung 1 weist zudem einen Ausgang 8 mit einem ersten Ausgangsanschluss 8.1 und einem zweiten Ausgangsanschluss auf, der mit der DC-Last 3 verbunden ist. Jeder der Eingangsanschlüsse 7.1, 7.2 ist über jeweils eine Verbindungsleitung 23, 24 mit jeweils einem korrespondierenden der Ausgangsanschlüsse 8.1, 8.2 verbunden. Zwischen dem Eingang 7 und dem Ausgang 8 ist eine Schalteinheit 10 angeordnet. Die Schalteinheit 10 ist, gegebenenfalls in Verbindung mit einer an dem Ausgang 8 der Schaltungsanordnung 1 anliegenden Spannung $U_{aus}$, ausgelegt, einen Leistungsfluss P zwischen der DC-Quelle 2 und dem Ausgang 8 während eines ersten Betriebsmodus BM1 zu ermöglichen und während eines zweiten Betriebsmodus BM2 zu unterdrücken. Beispielsweise kann ein Leistungsfluss P zwischen dem Eingang 7 und dem Ausgang 8 mittels der Schalteinheit 10 während des ersten Betriebsmodus BM1 ermöglicht und während des zweiten Betriebsmodus BM2 verhindert werden. Zu diesem Zweck weist die Schalteinheit 10 zumindest einen, gegebenenfalls auch mehrere ansteuerbare Schalter auf. Bei den Schaltern kann es sich um elektromechanische Schalter, vorteilhafterweise jedoch um Halbleiterschalter handeln. Die Schalteinheit 10 kann zudem auch einen oder mehrere nicht ansteuerbare Halbleiterschalter, insbesondere Dioden aufweisen. Die Schalteinheit 10 wird von einer Steuerungseinheit 5 angesteuert. Die Schaltungsanordnung 1 beinhaltet zusätzlich eine Messeinheit 4, die ausgelegt ist, eine an dem Ausgang 8 der Schaltungsanordnung 1 anliegende Ausgangsspannung $U_{aus}$ und/oder einen über den Ausgang 8 fließenden Ausgangsstrom $I_{aus}$ zu messen. Alternativ oder kumulativ kann die Messeinheit 4 auch ausgelegt sein, eine an dem Eingang 7 anliegende Eingangsspannung $U_{ein}$ und/oder einen über den Eingang 7 fließenden Eingangsstrom $I_{ein}$ zu messen (in Fig. 1 nicht dargestellt). Die Messeinheit 4 ist zum Zwecke der Kommunikation und Ansteuerung mit der Steuerungseinheit 5 verbunden. Die Schaltungsanordnung 1 kann optional eine - in Figur 1 gestrichelt illustrierte - Ausgangskapazität 11 umfassen, die parallel zu ihrem Ausgang 8 verschaltet ist. Alternativ oder kumulativ kann die Schaltungsanordnung 1 eine Eingangskapazität umfassen, die parallel zu ihrem Eingang 7 verschaltet ist (in Fig. 1 nicht gezeigt).

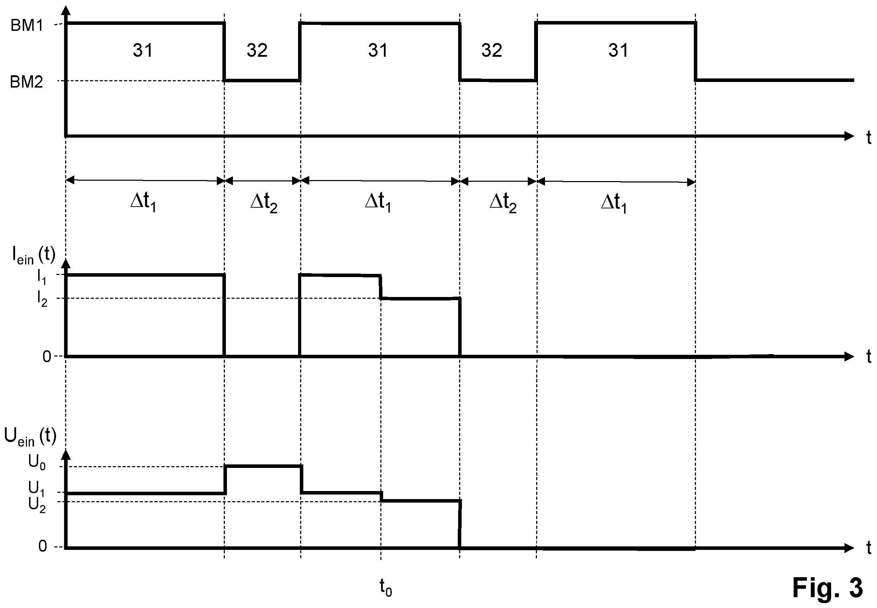

In einem Betrieb der Schaltungsanordnung 1 wird nun ein Leistungsfluss P zwischen der DC-Quelle 2 und dem Ausgang 8 der Schaltungsanordnung 1 mittels der Schalteinheit 10 - und gegebenenfalls in Verbindung mit einer an dem Ausgang 8 der Schaltungsanordnung 1 anliegenden Ausgangsspannung $U_{aus}$ - zyklisch, d.h. einer Regel genügend und wiederholt unterbrochen. Ein Leistungsfluss P zwischen der DC-Quelle 2 und dem Ausgang 8 erfolgt daher diskontinuierlich, wobei sich - wie in Verbindung mit Fig. 3 erläutert - aktive Zeitfenster 31 mit einer ersten Zeitdauer $\Delta t_1$ mit deaktiven Zeitfenstern 32 mit einer zweiten Zeitdauer $\Delta t_2$ abwechseln. Während der aktiven Zeitfenster 31 erfolgt somit ein von 0 verschiedener Leistungsfluss P zwischen der DC-Quelle 2 und dem Ausgang 8, wobei der Leistungsfluss P in den deaktiven Zeitfenstern 32 den Wert 0 annimmt.

Während zwei aufeinanderfolgenden aktiven Zeitfenstern 31 wird nun jeweils ein Strom I und/oder eine Spannung U mittels der Messeinheit 4 bestimmt und an die Steuerungseinheit 5 kommuniziert. Bei dem Strom I kann es sich um den Eingangsstrom $I_{ein}$ oder den Ausgangsstrom $I_{aus}$, bei der Spannung kann es sich um die Eingangsspannung $U_{ein}$ oder die Ausgangsspannung $U_{aus}$ handeln. Mittels der Steuerungseinheit 5 werden die Werte des Stroms I und/oder der Spannung U der aufeinanderfolgenden aktiven Zeitfenster 31 miteinander verglichen. Die Steuerungseinheit 5 ist eingerichtet, einen Lichtbogen 9, insbesondere einen Serien-Lichtbogen zu signalisieren, wenn die Werte von Strom I und/oder Spannung U des zeitlich nachfolgenden aktiven Zeitfensters 31 um mindestens einen Schwellwert von den entsprechenden Werten von Strom I und/oder Spannung U des vorangegangenen aktiven Zeitfensters 31 abweichen.

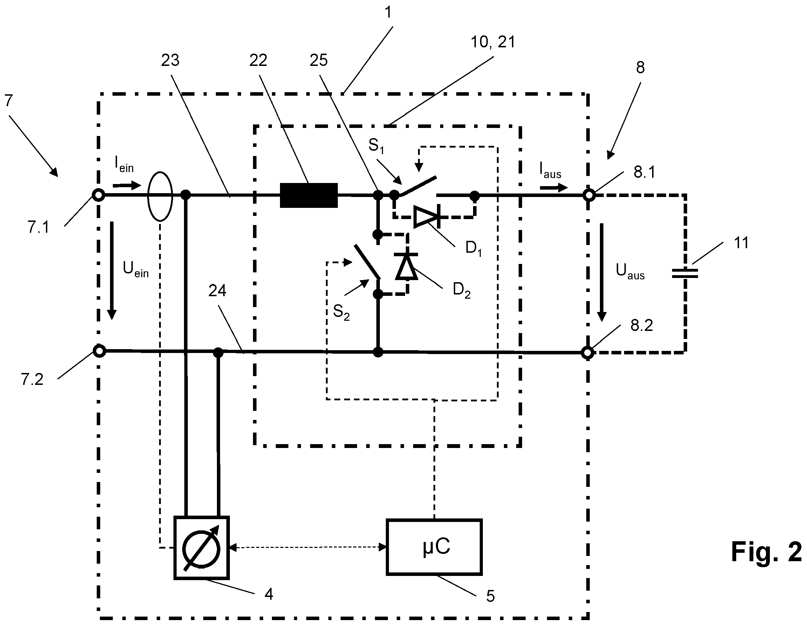

In **Fig. 2** ist eine erfindungsgemäße Schaltungsanordnung 1 in einer zweiten Ausführungsform dargestellt. Sie ähnelt in einigen Komponenten der bereits in Figur 1 beschriebenen ersten Ausführungsform, weswegen bei den übereinstimmenden Merkmalen auf die Beschreibungen unter Figur 1 verwiesen wird. Im Folgenden werden hauptsächlich die Unterschiede der zweiten Ausführungsform relativ zur ersten Ausführungsform erläutert.

Gemäß der zweiten Ausführungsform ist die Schaltungsanordnung 1 als DC/DC-Wandler 21, insbesondere als Hochsetzsteller ausgelegt und eingerichtet, eine an dem Eingang 7 anliegende Eingangsspannung $U_{ein}$ in eine an dem Ausgang 8 anliegende Ausgangsspannung $U_{aus}$ zu wandeln. Zu diesem Zweck weist die Schalteinheit 10 der Schaltungsanordnung 1 eine Induktivität 22 und einen seriell dazu verschalteten ersten

Halbleiterschalter $S_1$ innerhalb der ersten Verbindungsleitung 23 zwischen dem ersten Eingangsanschluss 7.1 und dem ersten Ausgangsanschluss 8.1 auf. Ein zweiter Halbleiterschalter $S_2$ ist mit seinem ersten Anschluss mit einem Verbindungspunkt 25 der Induktivität 22 und dem ersten Halbleiterschalter $S_1$ und mit seinem zweiten Anschluss mit der zweiten Verbindungsleitung 24 verbunden. Der erste $S_1$ und der zweite Halbleiterschalter $S_2$ können jeweils eine in Figur 2 gestrichelt illustrierte intrinsische oder separat ausgebildete Freilaufdiode $D_1$, $D_2$ aufweisen.

Während des ersten Betriebsmodus BM1, mit anderen Worten in dem in Fig. 3 dargestellten aktiven Zeitfenster 31 mit der ersten Zeitdauer $\Delta t_1$, operiert die Schaltungsanordnung 1 als Hochsetzsteller und wandelt mittels einer geeigneten Taktung des ersten $S_1$ und gegebenenfalls des zweiten Halbleiterschalters $S_2$ die Eingangsspannung $D_{ein}$ in eine relativ zur Eingangsspannung $U_{ein}$ größere Ausgangsspannung $U_{aus}$ um. Dabei ist die Ausgangsspannung $U_{aus}$ vorteilhafterweise so gewählt, dass sie größer als eine Leerlaufspannung $U_0$ einer an dem Eingang 7 angeschlossenen DC-Quelle 2 (in Fig. 2 nicht dargestellt) ist. Eine der Ausgangsspannung $U_{aus}$ zugeordnete Energie wird in einer parallel zu dem Ausgang 8 angeordneten Ausgangskapazität 11 zwischengespeichert. In dem zweiten Betriebsmodus BM2, also in dem in Fig. 3 illustrierten deaktiven Zeitfenster 32 mit der zweiten Zeitdauer $\Delta t_2$, wird die Taktung der Halbleiterschalter $S_1$, $S_2$ durch die Steuerungseinheit 5 unterbrochen. Die Halbleiterschalter $S_1$, $S_2$ sind während des zweiten Betriebsmodus BM2 dauerhaft geöffnet. Die zweite Zeitdauer $\Delta t_2$ kann über einige wenige Taktzyklen des DC/DC-Wandlers 21 andauern. Da nun die am Ausgang 8 anliegende Spannung $U_{aus}$ so gewählt ist, dass sie größer als die Leerlaufspannung $U_0$ der am Eingang angeschlossenen DC-Quelle 2 ist, sperrt die gegebenenfalls vorhandene dem ersten Halbleiterschalter $S_1$ zugeordnete Freilaufdiode $D_1$ einen Stromfluss von dem ersten Eingangsanschluss 7.1 zu dem ersten Ausgangsanschluss 8.1, und damit einen Leistungsfluss P von der DC-Quelle 2 zum Ausgang 8 der Schaltungsanordnung 1.

Mittels der Steuereinheit 5 wird die Schaltungsanordnung 1 in alternierender Weise während der ersten Zeitdauer $\Delta t_1$ in den ersten Betriebsmodus BM1 und während der zweiten Zeitdauer $\Delta t_2$ in den zweiten Betriebsmodus BM1 gesetzt, wodurch ein diskontinuierlicher Leistungsfluss P von der DC-Quelle 2 zum Ausgang 8 der Schaltungsanordnung 1 erzeugt wird. Eine Detektion und Auswertung der Werte von Strom I und/oder Spannung U in zwei zeitlich aufeinanderfolgenden aktiven Zeitfenstern 31, sowie eine Signalisierung eines Lichtbogens basierend auf dem Vergleich erfolgt mittels der Steuerungseinheit 5 wie bereits in Verbindung mit Fig. 1 beschrieben.

In **Fig. 3** sind Zeitverläufe für Betriebsmodi BM1, BM2 der Schalteinheit 10 der Schaltungsanordnung 1 (oberes Diagramm), sowie Strom I(t) (mittleres Diagramm) und Spannung U(t) (unteres Diagramm) der Schaltungsanordnung 1 aus Fig. 2 während des erfindungsgemäßen Verfahrens untereinander dargestellt. Bei den Zeitverläufen von Strom und Spannung handelt es sich exemplarisch jeweils um die mittels der Messeinheit 4 am Eingang 7 der Schaltungsanordnung 1 detektierten Größen $I_{ein}(t)$, $U_{ein}(t)$. Dabei spiegeln die Zeitverläufe das Verhalten der Schaltungsanordnung 1 in zeitlicher Nähe zu einem bei der Zeit $t_0$ zündenden Serien-Lichtbogen 9 wider.

Wie in dem oberen Diagramm illustriert, wechseln sich aktive Zeitfenster 31 der Zeitdauer $\Delta t_1$, bei denen die Schaltungsanordnung 1 in dem ersten Betriebsmodus BM1 vorliegt, mit deaktiven Zeitfenstern 32 der Zeitdauer $\Delta t_2$, bei denen die Schaltungsanordnung in dem zweiten Betriebsmodus BM2 vorliegt, ab. In dem ersten aktiven Zeitfenster 31 nimmt der Strom $I_{ein}(t)$ den Wert $I_1$ und die Spannung $D_{ein}(t)$ den Wert $U_1$ an. Die Werte des Stroms $I_1$ und der Spannung $U_1$ ergeben sich aus dem Leistungsverbrauch der an den Ausgang 8 der Schaltungsanordnung 1 angeschlossenen DC-Last 3. In dem unmittelbar angrenzenden deaktiven Zeitfenster 32 wird der Leistungsfluss P zwischen der DC-Quelle 2 und dem Ausgang 8 der Schaltungsanordnung 1 für die zweite Zeitdauer $\Delta t_2$ unterbrochen. Der über den Eingang 7 fließende Strom $I_{ein}(t)$ nimmt einen Wert von 0 A an, während die am Eingang 7 anliegende Spannung $U_{ein}(t)$ der Leerlaufspannung $U_0$ der DC-Quelle 2 entspricht. Die Leerlaufspannung $U_0$ ist aufgrund eines stets vorhandenen Innenwiderstandes einer realen DC-Quelle 2, beispielsweise PV-Generators, üblicherweise höher als die Spannung $U_1$ der belasteten DC-Quelle 2. In dem nächsten, hier: dem zweiten, aktiven Zeitfenster 31 entspricht der Strom $I_{ein}(t)$ zunächst dem Wert des vorangegangenen aktiven Zeitfensters 31 bis zu dem Zeitpunkt $t_0$, bei dem der Lichtbogen 9 in dem DC-Kreis 6, insbesondere zwischen der DC-Quelle 2 und dem Eingang der Schaltungsanordnung 1 zündet. Ab dem Zeitpunkt $t_0$ ergibt sich ein schlagartiges geringes Absinken der Werte von Strom, gegebenenfalls auch der Spannung, von den ursprünglichen Werten $I_1$, $U_1$ auf die Werte $I_2$, $U_2$. Das schlagartige Absinken des Stroms basiert auf einer Verlustleistung und einem damit verbundenen Spannungsabfall eines ab $t_0$ einsetzenden Serien-Lichtbogens 9. Der Serien-Lichtbogen 9 brennt beispielsweise über einem Mikrospalt in einem gebrochenen Leiter. In dem angrenzenden deaktiven Zeitfenster 32 wird der Serien-Lichtbogen 9 gelöscht, indem der Leistungsfluss P zwischen DC-Quelle 2 und Ausgang 8 der Schaltungsanordnung 1 erneut unterbrochen wird. Der über den Eingang 7 fließende Strom $I_{ein}(t)$ nimmt wieder den Wert 0A an. Die am Eingang 7 anliegende Spannung $U_{ein}(t)$ in dem zweiten deaktiven Zeitfenster 32 ist aufgrund des vor dem Eingang liegenden Mikrospaltes nun nicht mehr über die DC-Quelle 2 definiert, sondern vielmehr durch die am Ausgang 8 anliegende Spannung $U_{aus}(t)$ und ein Impedanzverhältnis der geöffneten Halbleiterschalter $S_1$, $S_2$. Diese wirken nämlich als Spannungsteiler der am Ausgang 8 anliegenden Spannung $U_{aus}$ (t). Für den Verlauf der Spannung $D_{ein}$ (t) ist zusätzlich zu berücksichtigen, dass sich die am Ausgang 8 anliegende Spannung $U_{aus}$ (t), abhängig von einem gegebenenfalls stattfindenden Stromfluss durch die DC-Last 3, mehr oder weniger stark entladen kann. In jedem Fall unterscheidet sich die am Eingang anliegende Spannung $U_{ein}$(t) deutlich von der Leerlaufspannung $U_0$ der DC-Quelle 2. In Fig. 3 ist in dem zweiten deaktiven Zeitfenster 32 exemplarisch ein Wert der Spannung $D_{ein}$ (t) von nahezu 0V illustriert. In dem darauffolgenden dritten aktiven Zeitfenster 31 wird ein Leistungsfluss P durch die Schalteinheit 10 zwar prinzipiell ermöglicht, allerdings wird er nun durch den Mikrospalt verhindert, weswegen in Fig. 3 vernachlässigbar geringe Werte von Spannung $U_{ein}$ (t) und Strom $I_{ein}$ (t) illustriert sind.

Die Steuerungseinheit 5 vergleicht nun die von der Messeinheit 4 detektierten Werte von Strom $I_{ein}$(t) und/oder Spannung $U_{ein}$(t) der aktiven Zeitfensters 31 mit den Werten des jeweils vorangegangenen aktiven Zeitfensters 31. Bei dem Vergleich der Werte zwischen dem zweiten 31 und dem dritten aktiven Zeitfenster 31 in Fig. 3 stellt die Steuerungseinheit 5 einen Unterschied dieser Werte fest, der einen Schwellwert übersteigt und signalisiert in Reaktion darauf einen Lichtbogen 9. In Reaktion auf die Signalisierung des Lichtbogens 9 verbleibt die Schalteinheit 10 bis zur manuellen Quittierung durch eine Fachkraft in dem zweiten Betriebsmodus BM2, wobei ein Leistungsfluss P zwischen DC-Quelle 2 und Ausgang 8 unterdrückt wird.

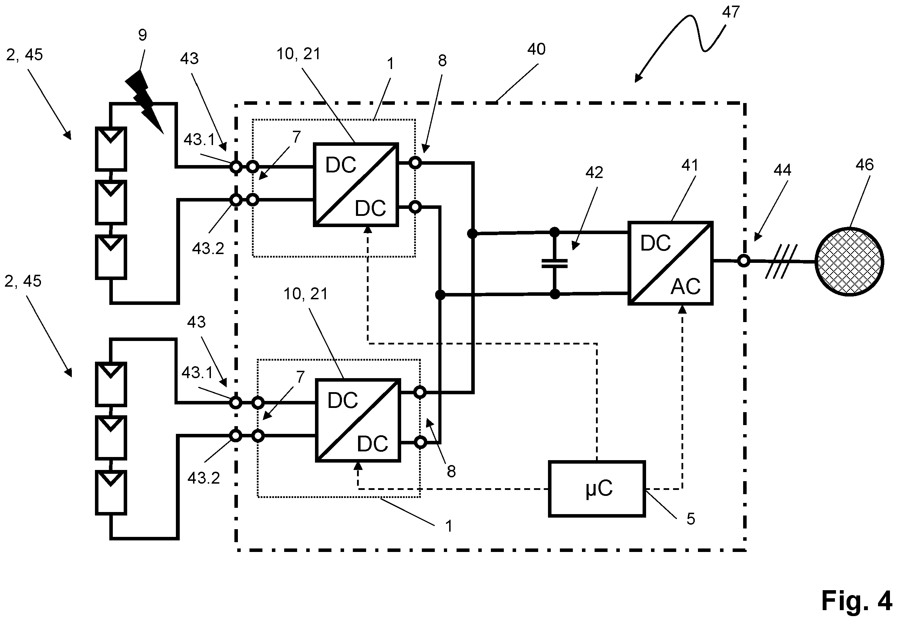

In **Fig. 4** ist eine Photovoltaik (PV) - Anlage 47 mit einem erfindungsgemäßen PV - Wechselrichter 40 in einer Ausführungsform illustriert. Dabei ist der PV-Wechselrichter 40 als so genannter Multistring-Wechselrichter mit mehreren (hier exemplarisch: zwei) DC-seitigen Eingängen 43 mit Eingangsanschlüssen 43.1 und 43.2 zum Anschluss jeweils eines PV-Strings 45 als DC-Quelle 2 ausgebildet. Jeder der Eingänge 43 ist über jeweils einen DC/DC-Wandler 21, hier über einen Hochsetzsteller, parallel zueinander mit einer Zwischenkreis-Kapazität eines gemeinsamen DC-Zwischenkreises 42 verbunden. Die Zwischenkreis-Kapazität ist mit einem Eingang eines DC/AC-Wandlers 41 verbunden. Der Ausgang des DC/AC-Wandlers 41 ist über entsprechende AC-Trennelemente (in Fig. 4 nicht dargestellt) über einen Ausgang 44 des PV-Wechselrichters 40 mit einem Wechselspannungs (AC) - Netz 46 verbunden.

Der PV-Wechselrichter 40 umfasst für jeden der DC-seitigen Eingänge 43 jeweils eine Schaltungsanordnung 1. Dabei sind die Schaltungsanordnungen 1, insbesondere deren Schalteinheiten 10, jeweils als DC/DC-Wandler ausgebildet und werden zumindest teilweise von den ohnehin vorhandenen DC/DC-Wandlern 21 des PV-Wechselrichters 40 gebildet. Die Eingänge 7 der Schaltungsanordnungen 1 entsprechen dabei den Eingängen 43 des PV-Wechselrichters 40. Die Ausgänge 8 der Schaltungsanordnungen 1 entsprechen dabei jeweils den Ausgängen der DC/DC-Wandler 21. Die Schaltungsanordnungen 1 weisen eine gemeinsame Steuerungseinheit 5 auf, die Bestandteil einer zentralen Steuerungseinheit des PV-Wechselrichters 40 ist und zur Ansteuerung der DC/DC-Wandler 21 und des DC/AC-Wandlers 41 ausgelegt und eingerichtet ist. Die Messeinheiten 4 der Schaltungsanordnungen sind ebenfalls Bestandteil der DC/DC-Wandler 21 und in Fig. 4 nicht explizit illustriert.

Das erfindungsgemäße Verfahren wird über die Steuerungseinheit 5 gleichzeitig für jede als PV-String 45 ausgebildete DC-Quelle 2 durchgeführt. Jeder der PV-Strings 45 weist also im normalen Betrieb des PV-Wechselrichters 40 einen diskontinuierlichen Leistungsfluss P innerhalb seiner jeweiligen DC-Leitungen zwischen den PV-Modulen und dem entsprechenden DC-seitigen Eingang 43 des PV-Wechselrichters 40 auf. Dabei wechseln sich aktive Zeitfenster 31 mit einer ersten Zeitdauer $\Delta t_1$ mit deaktiven Zeitfenstern 32 mit einer zweiten Zeitdauer $\Delta t_2$ in alternierender Weise ab. Vorteilhafterweise kann der diskontinuierliche Leistungsfluss P innerhalb der beiden PV-Strings 45 dabei so erfolgen, dass ein möglichst geringer Überlapp von den deaktiven Zeitfenstern 32 des einen PV-Strings 45 mit den deaktiven Zeitfenstern des anderen PV-Strings 45 erfolgt, die deaktiven Zeitfenster also möglichst versetzt zueinander angeordnet sind. Wird nun mittels der Steuerungseinheit 5 innerhalb eines der PV-Strings 45 ein Lichtbogen 9, insbesondere ein Serien-Lichtbogen bestimmt, so wird nur diejenige der Schalteinheit 10, das heißt derjenige der DC/DC-Wandler 21, für einen längeren Zeitraum - und gegebenenfalls bis zu einer manuellen Quittierung durch eine Fachkraft - in den zweiten Betriebsmodus BM2 versetzt, die/der demjenigen PV-String 45 zugeordnet ist, in dem auch der Serien-Lichtbogen 9 detektiert wurde. Der jeweils andere PV-String 45 kann hingegen weiter mit einem diskontinuierlichen Leistungsfluss P in Richtung seines zugeordneten DC-seitigen Eingangs 43 betrieben werden.

### Bezugszeichenliste

| | |
|---|---|
| 1 | Schaltungsanordnung |
| 2 | DC-Quelle |
| 3 | DC-Last |
| 4 | Messeinheit |
| 5 | Steuerungseinheit |
| 6 | Gleichstrom (DC) - Kreis |
| 7 | Eingang |
| 7.1, 7.2 | Eingangsanschluss |
| 8 | Ausgang |
| 8.1, 8.2 | Ausgangsanschluss |
| 9 | Lichtbogen (seriell) |
| 10 | Schalteinheit |
| 11 | Ausgangskapazität |
| 21 | DC/DC-Wandler |
| 22 | Induktivität |

| | |
|---|---|
| 23, 24 | Verbindungsleitung |
| 25 | Verbindungspunkt |
| 31, 32 | Zeitfenster |
| 40 | Photovoltaik (PV) - Wechselrichter |
| 41 | DC/AC - Wandler |
| 42 | DC-Zwischenkreis |
| 43 | Eingang |
| 43.1, 43.2 | Eingangsanschluss |
| 44 | Ausgang |
| 45 | PV-String |
| 46 | Wechselspannungs (AC) - Netz |
| 47 | Photovoltaik (PV) - Anlage |
| $\Delta t_1$, $\Delta t_2$ | Zeitfenster |
| $S_1$, $S_2$ | Halbleiterschalter |
| BM1, BM2 | Betriebsmodus |
| $D_1$, $D_2$ | Diode |
| P | Leistungsfluss |
| $D_{ein}$ | Eingangsspannung |
| $U_{aus}$ | Ausgangsspannung |
| $I_{ein}$ | Eingangsstrom |
| $I_{aus}$ | Ausgangsstrom |

**Patentansprüche**

1. Verfahren zur Detektion eines Lichtbogens (9) in einem Gleichstrom, DC, - Kreis (6) mit einer DC-Last (3), einer die DC-Last (3) versorgenden DC-Quelle (2) und einer zwischen der DC-Quelle (2) und der DC-Last (3) angeordneten Schaltungsanordnung (1),

    - wobei die Schaltungsanordnung (1) einen Eingang (7) mit zwei Eingangsanschlüssen (7.1, 7.2) zum Anschluss der DC-Quelle (2), einen Ausgang (8) mit zwei Ausgangsanschlüssen (8.1, 8.2) zum Anschluss der DC-Last (3), und eine zwischen dem Eingang (7) und dem Ausgang (8) angeordnete Schalteinheit (10) umfasst,
    - wobei die Schalteinheit (10), gegebenenfalls in Verbindung mit einer an dem Ausgang der Schaltungsanordnung (1) anliegenden Ausgangsspannung $U_{aus}$, in einem ersten Betriebsmodus BM1 ausgelegt ist, einen Leistungsfluss P zwischen der DC-Quelle (2) und dem Ausgang (8) zu ermöglichen und in einem zweiten Betriebsmodus BM2 ausgelegt ist, den Leistungsfluss zwischen der DC-Quelle (2) und dem Ausgang (8) zu unterdrücken,

    **mit den Verfahrensschritten:**

    - Zyklisches Unterbrechen des Leistungsflusses P zwischen der DC-Quelle (2) und dem Ausgang (8), insbesondere zwischen dem Eingang (7) und dem Ausgang (8) mittels der Schalteinheit (10), so dass der Leistungsfluss P in einem aktiven Zeitfenster (31) mit der ersten Zeitdauer $\Delta t_1$ ermöglicht wird, und der Leistungsfluss P in einem deaktiven Zeitfenster (32) mit der zweiten Zeitdauer $\Delta t_2$ unterdrückt wird,
    - Detektion eines den Leistungsfluss P charakterisierenden Stroms I und/oder einer den Leistungsfluss P charakterisierenden Spannung U in zwei aufeinanderfolgenden aktiven Zeitfenstern (31),
    - Vergleich der detektierten Werte von Strom I und/oder Spannung U des aktiven Zeitfensters (31) mit den korrespondierenden detektierten Werten aus dem vorangegangenen aktiven Zeitfenster (31), und
    - Signalisierung eines Lichtbogens (9), wenn sich die Werte von Strom I und/oder Spannung U des aktiven Zeitfensters (31) von den korrespondierenden Werten des vorangegangenen aktiven Zeitfensters (31) um mehr als einen Schwellwert unterscheiden.

2. Verfahren nach Anspruch 1, wobei in Reaktion auf einen signalisierten Lichtbogen (9) der Leistungsfluss P zwischen der DC-Quelle (2) und dem Ausgang (8) mittels der Schalteinheit (10) dauerhaft, zumindest jedoch für einen Zeitraum von einigen Minuten, optional bis zu einer manuellen Quittierung unterbrochen wird.

3. Verfahren nach Anspruch 1 oder 2, wobei das aktive Zeitfenster (31) und das vorangegangene aktive Zeitfenster (31) durch genau ein deaktives Zeitfenster (32) voneinander getrennt sind.

4. Verfahren nach einem der Ansprüche 1 bis 3, wobei ein Wert der zweiten Zeitdauer $\Delta t_2$ der deaktiven Zeitfenster (32) ausreichend ist, einen in dem DC-Kreis (6) gegebenenfalls vorhandenen Lichtbogen (9) zu löschen und ein erneutes Zünden des in dem deaktiven Zeitfenster (32) gelöschten Lichtbogens (9) in dem auf das deaktive Zeitfenster (32) unmittelbar zeitlich nachfolgenden aktiven Zeitfenster (31) zu unterdrücken.

5. Verfahren nach einem der vorangehenden Ansprüche, wobei ein Wert der zweiten Zeitdauer $\Delta t_2$ in Abhängigkeit von detektierten Werten von Strom I und/oder Spannung U des unmittelbar vorangegangenen aktiven Zeitfensters (31) gewählt wird, und wobei insbesondere die zweite Zeitdauer $\Delta t_2$ mit steigendem Wert des Stroms I und/oder der Spannung U ansteigt.

6. Verfahren nach einem der Ansprüche 1 bis 4, wobei die Schaltungsanordnung (1) eine parallel zu ihrem Eingang (7) verschaltete Eingangskapazität aufweist, wobei zusätzlich in dem deaktiven Zeitfenster (32) ein an dem Eingang (7) fließender Eingangsstrom $I_{ein}$ und/oder eine an dem Eingang (7) zwischen den Eingangsanschlüssen (7.1, 7.2) anliegende Eingangsspannung $U_{ein}$ detektiert wird, und wobei die zweite Zeitdauer $\Delta t_2$ des deaktiven Zeitfensters (32) in Abhängigkeit von dem detektierten Eingangsstrom $I_{ein}$ und/oder von der detektierten Eingangsspannung $U_{ein}$ bestimmt wird.

7. Verfahren nach einem der vorangehenden Ansprüche, wobei die Schaltungsanordnung (1) eine parallel zu ihrem Eingang (7) verschaltete Eingangskapazität aufweist, und wobei in dem deaktiven Zeitfenster (32) ein an dem Eingang fließender Eingangsstrom $I_{ein}$ über eine zeitliche Änderung der an der Eingangskapazität anliegenden Eingangsspannung $U_{ein}$ gemessen wird.

8. Verfahren nach einem der vorangehenden Ansprüche, wobei die Schalteinheit (10) durch einen DC/DC-Wandler, insbesondere einen Hochsetzsteller gebildet wird und die Schaltungsanordnung (1) eine parallel mit dem Ausgang (7) verbundene Ausgangskapazität (11) aufweist, und wobei in dem aktiven Zeitfenster (31) eine an der Ausgangskapazität (11) anliegende Spannung $U_{aus}$ zu einem Ende der ersten Zeitdauer $\Delta t_1$ hin durch die Schalteinheit (10) vergrößert wird.

9. Verfahren nach einem der vorangehenden Ansprüche, wobei ein Wert der ersten Zeitdauer $\Delta t_1$ des aktiven Zeitfensters (31) so gewählt ist, dass eine Lichtbogenenergie, die von einer Verlustleistung eines in dem aktiven Zeitfenster (31) angenommenen Lichtbogens generiert würde, einen vorgegebenen maximal erlaubten Energiewert $E_{max}$, insbesondere einen Wert von $E_{max}$ = 200 J nicht überschreitet.

10. Verfahren nach einem der vorangehenden Ansprüche, wobei die DC-Quelle (2) einen PV-String (43) und die DC-Last (3) einen einphasigen, ausgangsseitig mit einem Wechselspannungs, AC, - Netz (45) verbundenen DC/AC-Wandler (41) aufweist, und wobei das zyklische Unterbrechen des Leistungsflusses P derart erfolgt, dass ein Nulldurchgang eines über einen Ausgang des DC/AC-Wandlers (41) fließenden AC-Stroms $I_{AC}$ (t) während der zweiten Zeitdauer $\Delta t_2$ des deaktiven Zeitfensters (32) erfolgt.

11. Verfahren nach einem der vorangehenden Ansprüche, wobei mehrere DC-Quellen (2) über jeweils eine Schalteinheit (10) parallel zueinander mit der DC-Last (3) verbunden sind, um mit ihren jeweiligen Leistungsflüssen P die DC-Last (3) gemeinsam zu versorgen, wobei das Verfahren gleichzeitig für jede der DC-Quellen (2) so durchgeführt wird, dass ein zeitlicher Überlapp der deaktiven Zeitfenster (32) der mehreren DC-Quellen (2) minimiert ist.

12. Schaltungsanordnung (1) zur Detektion eines Lichtbogens (9) in einem DC-Kreis (6) aufweisend:

    - einen Eingang (7) mit zwei Eingangsanschlüssen (7.1, 7.2) zum Anschluss einer DC-Quelle (2), und einen Ausgang (8) mit zwei Ausgangsanschlüssen (8.1, 8.2) zum Anschluss einer DC-Last (3),
    - eine zwischen dem Eingang (7) und dem Ausgang (8) angeordnete Schalteinheit (10), wobei die Schalteinheit (10), gegebenenfalls in Verbindung mit einer an dem Ausgang der Schaltungsanordnung (1) anliegenden Ausgangsspannung $U_{aus}$, in einem ersten Betriebsmodus (BM1) zur Freigabe eines Leistungsflusses P zwischen dem Eingang (7) und dem Ausgang (8) und in einem zweiten Betriebsmodus (BM2) zur Unterdrückung eines Leistungsflusses P zwischen dem Eingang (7) und dem Ausgang (8) ausgelegt ist,
    - eine Messeinheit (4) zur Bestimmung einer an dem Eingang (7) oder dem Ausgang (8) anliegenden Spannung U und/oder eines in einer Verbindungsleitung (23, 24) von einem der Eingangsanschlüsse (7.1, 7.2) zu einem der Ausgangsanschlüsse (8.1, 8.2) fließenden Stroms I, und
    - eine Steuerungseinheit (5) zur Steuerung der Schalteinheit (10) und gegebenenfalls der Messeinheit (4),

**dadurch gekennzeichnet, dass**
die Steuerungseinheit (5) in Verbindung mit der Schalteinheit (10) und der Messeinheit (4) zur Durchführung des Verfahrens nach einem der voranstehenden Ansprüche ausgelegt und eingerichtet ist.

13. Schaltungsanordnung (1) nach Anspruch 12, **dadurch gekennzeichnet, dass** die Schalteinheit (10) einen in einer der Verbindungsleitungen (23, 24) angeordneten Halbleiterschalter aufweist, wobei der Halbleiterschalter frei von einer Freilaufdiode ist, oder wobei der Halbleiterschalter eine intrinsische Freilaufdiode aufweist, die in Bezug auf eine normale Stromrichtung des DC-Kreises (6) in Sperrrichtung gepolt ist.

14. Schaltungsanordnung (1) nach Anspruch 12 oder 13, **dadurch gekennzeichnet, dass** die Schaltungsanordnung (1) oder die Schalteinheit (10) der Schaltungsanordnung (1) als DC/DC-Wandler (21), insbesondere als Hochsetzsteller ausgelegt ist.

15. Photovoltaik, PV, - Wechselrichter (40) umfassend:

    - zumindest einen Eingang (43) mit zwei Eingangsanschlüssen (43.1, 43.2) zum Anschluss eines PV-Strings (45) als DC-Quelle (2) und einen Ausgang (44) zum Anschluss an ein Wechselspannungs, AC, - Netz (46),
- einen DC/AC-Wandler (41) zur Wandlung einer Gleichspannung in eine Wechselspannung, und
- eine Schaltungsanordnung (1) nach einem der Ansprüche 12 bis 14, deren Eingang (7) mit dem zumindest einen Eingang (43) des PV-Wechselrichters (40) und deren Ausgang (8) mit einem Eingang des DC/AC-Wandlers (41) verbunden ist.

16. PV - Wechselrichter (40) nach Anspruch 15, mit einer Mehrzahl von Eingängen (43) zum Anschluss jeweils eines PV-Strings (45) als DC-Quelle (2), wobei die Eingänge (43) jeweils über einen DC/DC-Wandler (21) parallel zueinander mit einem gemeinsamen DC-Zwischenkreis (42) verbunden sind, und wobei der DC-Zwischenkreis (42) mit einem Eingang des DC/AC-Wandlers (41) verbunden ist, und mit mehreren Schaltungsanordnungen (1) nach einem der Ansprüche 12 bis 14, wobei jeder der Eingänge (43) des PV-Wechselrichters (40) jeweils mit dem Eingang (7) einer ihm zugeordneten Schaltungsanordnung (1) verbunden ist, und wobei der Ausgang (8) jeder der Schaltungsanordnungen (1) jeweils mit dem Eingang des DC/AC-Wandlers (42) verbunden ist.

17. PV - Wechselrichter (40) nach Anspruch 16, wobei die Steuerungseinheit (5) gleichzeitig eingerichtet ist, den DC/AC-Wandler (41) und die DC/DC-Wandler (21) des PV-Wechselrichters (40) derart zu steuern, dass im Betrieb des PV-Wechselrichters (40) eine an dem DC-Zwischenkreis (42) anliegende Spannung oberhalb eines Maximalwertes der Leerlaufspannungen der einzelnen PV-Strings (45) gehalten wird.

**Claims**

1. A method for detecting an arc (9) in a direct-current (DC) circuit (6) comprising a DC load (3), a DC source (2) supplying the DC load (3), and a circuit arrangement (1) arranged between the DC source (2) and the DC load (3),

    - wherein the circuit arrangement (1) comprises an input (7) comprising two input terminals (7.1, 7.2) for connecting the DC source (2), an output (8) comprising two output terminals (8.1, 8.2) for connecting the DC load (3), and a switching unit (10) arranged between the input (7) and the output (8),
    - wherein the switching unit (10), optionally in connection with an output voltage $U_{out}$ applied to the output of the circuit arrangement (1), is designed to enable a power flow P between the DC source (2) and the output (8) in a first operating mode BM1 and is designed to suppress the power flow between the DC source (2) and the output (8) in a second operating mode BM2,

**comprising the method steps of:**

    - cyclical interruption of the power flow P between the DC source (2) and the output (8), in particular between the input (7) and the output (8), by means of the switching unit (10) such that the power flow P is enabled in an active time window (31) with the first period $\Delta t_1$ and the power flow P is suppressed in an inactive time window (32) with the second period $\Delta t_2$,
    - detection of a current I characterizing the power flow P and/or a voltage U characterizing the power flow P in two consecutive active time windows (31),
    - comparing the detected values of current I and/or voltage U of the active time window (31) with the corresponding detected values from the preceding active time window (31), and
    - signaling of an arc (9) if the values of current I and/or voltage U of the active time window (31) differ from the corresponding values of the preceding active time window (31) by more than a threshold value.

2. The method as claimed in claim 1, wherein, in response to a signaled arc (9), the power flow P between the DC source (2) and the output (8) is interrupted permanently, but at least for a period of several minutes, optionally until a manual acknowledgement, by means of the switching unit (10).

3. The method as claimed in claim 1 or 2, wherein the active time window (31) and the preceding active time window (31) are separated from one another by exactly one inactive time window (32).

4. The method as claimed in any one of claims 1 to 3, wherein a value of the second period $\Delta t_2$ of the inactive time window (32) is sufficient to quench an arc (9) that may be present in the DC circuit (6) and to suppress reignition of the arc (9) quenched in the inactive time window (32) in the active time window (31) that immediately chronologically follows the inactive time window (32).

5. The method as claimed in any one of the preceding claims, wherein a value of the second period $\Delta t_2$ is selected depending on detected values of current I and/or voltage U of the immediately preceding active time window (31), and wherein in particular the second period $\Delta t_2$ increases as a value of the current I and/or the voltage U increases.

6. The method as claimed in any one of claims 1 to 4, wherein the circuit arrangement (1) has an input capacitance connected in parallel with its input (7), wherein in addition, in the inactive time window (32), an input current $I_{in}$ flowing at the input (7) and/or an input voltage $U_{in}$ applied to the input (7) between the input terminals (7.1, 7.2) is detected, and wherein the second period $\Delta t_2$ of the inactive time window (32) is determined depending on the detected input current $I_{in}$ and/or on the detected input voltage $U_{in}$.

7. The method as claimed in any one of the preceding claims, wherein the circuit arrangement (1) has an input capacitance connected in parallel with its input (7), and wherein, in the inactive time window (32), an input current $I_{in}$ flowing at the input is measured by means of a change over time in the input voltage $U_{in}$ applied to the input capacitance.

8. The method as claimed in any one of the preceding claims, wherein the switching unit (10) is formed by a DC-DC converter, in particular a step-up converter, and the circuit arrangement (1) has an output capacitance (11) connected in parallel with the output (7), and wherein, in the active time window (31), a voltage $U_{out}$ applied to the output capacitance (11) is increased toward an end of the first period $\Delta t_1$ by the switching unit (10).

9. The method as claimed in any one of the preceding claims, wherein a value of the first period $\Delta t_1$ of the active time window (31) is selected in such a way that an arc energy that would be generated by a power loss of an assumed arc in the active time window (31) does not exceed a predetermined maximum permitted energy value $E_{max}$, in particular a value of $E_{max} = 200$ J.

10. The method as claimed in any one of the preceding claims, wherein the DC source (2) comprises a PV string (43) and the DC load (3) comprises a single-phase DC-AC converter (41) connected on the output side to an AC voltage (AC) grid (45), and wherein the cyclical interruption of the power flow P takes place in such a way that there is a zero crossing of an AC current $I_{AC}$ (t) flowing via an output of the DC-AC converter (41) during the second period $\Delta t_2$ of the inactive time window (32).

11. The method as claimed in any one of the preceding claims, wherein a plurality of DC sources (2) are each connected to the DC load (3) in parallel with one another via a switching unit (10) in order to jointly supply the DC load (3) with their respective power flows P, wherein the method is carried out simultaneously for each of the DC sources (2) in such a way that a temporal overlap of the inactive time windows (32) of the plurality of DC sources (2) is minimized.

12. A circuit arrangement (1) for detecting an arc (9) in a DC circuit (6), having:

- an input (7) comprising two input terminals (7.1, 7.2) for connecting a DC source (2), and an output (8) comprising two output terminals (8.1, 8.2) for connecting a DC load (3),
- a switching unit (10) arranged between the input (7) and the output (8), wherein the switching unit (10), optionally in connection with an output voltage $U_{out}$ applied to the output of the circuit arrangement (1), is designed to enable a power flow P between the input (7) and the output (8) in a first operating mode (BM1) and to suppress a power flow P between the input (7) and the output (8) in a second operating mode (BM2),
- a measuring unit (4) for determining a voltage U applied to the input (7) or to the output (8) and/or a current I flowing in a connection line (23, 24) from one of the input terminals (7.1, 7.2) to one of the output terminals (8.1, 8.2), and
- a control unit (5) for controlling the switching unit (10) and optionally the measuring unit (4),

**characterized in that**
the control unit (5) is configured and set up in connection with the switching unit (10) and the measuring unit (4) to carry out the method as claimed in any one of the preceding claims.

13. The circuit arrangement (1) as claimed in claim 12, **characterized in that** the switching unit (10) has a semiconductor switch arranged in one of the connection lines (23, 24), wherein the semiconductor switch is free of a freewheeling diode, or wherein the semiconductor switch has an intrinsic freewheeling diode that is reverse-biased with respect to a normal current direction of the DC circuit (6).

14. The circuit arrangement (1) as claimed in claim 12 or 13, **characterized in that** the circuit arrangement (1) or the switching unit (10) of the circuit arrangement (1) is designed as a DC-DC converter (21), in particular as a step-up converter.

15. A photovoltaic (PV) inverter (40) comprising:

- at least one input (43) comprising two input terminals (43.1, 43.2) for connecting a PV string (45) as a DC source (2) and an output (44) for connection to an AC voltage (AC) grid (46),
- a DC-AC converter (41) for converting a DC voltage to an AC voltage, and
- a circuit arrangement (1) as claimed in any one of claims 12 to 14, the input (7) of which is connected to the at least one input (43) of the PV inverter (40) and the output (8) of which is connected to an input of the DC-AC converter (41).

**16.** The PV inverter (40) as claimed in claim 15, comprising a plurality of inputs (43) for connecting a respective PV string (45) as a DC source (2), wherein the inputs (43) are each connected to a common DC link circuit (42) in parallel with one another via a DC-DC converter (21) each, and wherein the DC link circuit (42) is connected to an input of the DC-AC converter (41), and comprising a plurality of circuit arrangements (1) as claimed in one of claims 12 to 14, wherein each of the inputs (43) of the PV inverter (40) is connected to the respective input (7) of a circuit arrangement (1) assigned thereto, and wherein the output (8) of each of the circuit arrangements (1) is connected to the respective input of the DC-AC converter (42).

**17.** The PV inverter (40) as claimed in claim 16, wherein the control unit (5) is at the same time set up to control the DC-AC converter (41) and the DC-DC converter (21) of the PV inverter (40) in such a way that, during operation of the PV inverter (40), a voltage applied to the DC link circuit (42) is kept above a maximum value of the open circuit voltages of the individual PV strings (45).

**Revendications**

**1.** Procédé de détection d'arc électrique (9) dans un circuit de courant continu, DC (6) comportant une charge DC (3), une source DC (2) alimentant la charge DC (3) et un montage de circuit (1) placé entre la source DC (2) et la charge DC (3),

- le montage de circuit (1) comprenant une entrée (7) dotée de deux bornes d'entrée (7.1, 7.2) pour le raccordement de la source DC (2) et une sortie (8) dotée de deux bornes de sortie (8.1, 8.2) pour le raccordement de la charge DC (3), ainsi qu'une unité de commutation (10) placée entre l'entrée (7) et la sortie (8),
- l'unité de commutation (10), éventuellement associée à une tension de sortie $U_{aus}$ présente à la sortie du montage de circuit (1), étant configurée, selon un premier mode de fonctionnement BM1, de manière à permettre le passage d'un flux de puissance P entre la source DC (2) et la sortie (8) et, selon un deuxième mode de fonctionnement BM2, de manière à empêcher le passage du flux de puissance entre la source DC (2) et la sortie (8),

**à l'aide des étapes de procédé suivantes :**

- Interruption cyclique du flux de puissance P entre la source DC (2) et la sortie (8), en particulier entre l'entrée (7) et la sortie (8), au moyen de l'unité de commutation (10), de manière à permettre le passage du flux de puissance P au cours d'un intervalle de temps actif (31) ayant la première durée $\Delta t_1$, et à interrompre le passage du flux de puissance P au cours d'un intervalle de temps inactif (32) ayant la deuxième durée $\Delta t_2$,
- Détection d'un courant I caractérisant le flux de puissance P et/ou d'une tension U caractérisant le flux de puissance P dans deux intervalles de temps actifs successifs (31),
- Comparaison des valeurs de courant I et/ou de tension U détectées au cours de l'intervalle de temps actif (31) avec les valeurs correspondantes détectées au cours de l'intervalle de temps actif précédent (31), et
- Signalement d'un arc électrique (9) lorsque les valeurs du courant I et/ou de la tension U de l'intervalle de temps actif (31) diffèrent de plus d'une valeur limite des valeurs correspondantes de l'intervalle de temps actif précédent (31).

**2.** Procédé selon la revendication 1, dans lequel, en réponse à un arc électrique signalé (9), le flux de puissance P entre la source DC (2) et la sortie (8) est, au moyen de l'unité de commutation (10), interrompu de manière permanente, ou tout au moins pendant une durée de quelques minutes, optionnellement jusqu'à une interruption manuelle.

**3.** Procédé selon la revendication 1 ou 2, dans lequel l'intervalle de temps actif (31) et l'intervalle de temps actif précédent (31) sont séparés par exactement un intervalle de temps inactif (32).

**4.** Procédé selon l'une des revendications 1 à 3, dans lequel une valeur de la deuxième durée $\Delta t_2$ des intervalles de temps inactifs (32) est suffisante pour éteindre un arc électrique (9) éventuellement présent dans le circuit DC (6) et pour empêcher que l'arc électrique (9) éteint dans l'intervalle de temps inactif (32) soit à nouveau établi dans l'intervalle de temps actif (31) suivant immédiatement l'intervalle de temps inactive (32).

**5.** Procédé selon l'une quelconque des revendications qui précèdent, dans lequel une valeur de la deuxième durée $\Delta t_2$ est choisie en fonction des valeurs de courant I et/ou de tension U détectées au cours de l'intervalle de temps actif (31) immédiatement précédent, et dans lequel en particulier la deuxième durée $\Delta t_2$ augmente lorsque la valeur de courant I et/ou de tension U augmente.

**6.** Procédé selon l'une des revendications 1 à 4, dans lequel le montage de circuit (1) comporte une capacité d'entrée reliée en parallèle à son entrée (7), dans lequel, en outre, un courant d'entrée Iein circulant à l'entrée (7) et/ou une tension d'entrée $U_{ein}$ présente

à l'entrée (7) entre les bornes d'entrée (7.1, 7.2) sont détectées au cours de l'intervalle de temps inactif (32), et dans lequel la deuxième durée $\Delta t_2$ de l'intervalle de temps inactif (32) est déterminée en fonction des valeurs de courant d'entrée Iein et/ou de tension d'entrée $U_{ein}$ détectées.

7. Procédé selon l'une des revendications précédentes, dans lequel le montage de circuit (1) comporte une capacité d'entrée reliée en parallèle à son entrée (7), et dans lequel, au cours de l'intervalle de temps inactif (32), un courant d'entrée Iein circulant à l'entrée est mesuré à partir de la variation en fonction du temps de la tension d'entrée $U_{ein}$ présente au niveau de la capacité d'entrée.

8. Procédé selon l'une quelconque des revendications précédentes, dans lequel l'unité de commutation (10) consiste en un transducteur DC/DC, en particulier en un convertisseur élévateur, et le montage de circuit (1) comporte une capacité de sortie (11) reliée en parallèle à la sortie (7), et dans lequel, dans l'intervalle de temps actif (31), une tension $U_{aus}$ présente à la capacité de sortie (11) est augmentée par l'unité de commutation (10) vers la fin de la première durée $\Delta t_1$.

9. Procédé selon l'une quelconque des revendications précédentes, dans lequel une valeur de la première durée $\Delta t_1$ de l'intervalle de temps actif (31) est choisie de manière à ce qu'une énergie d'arc générée par la puissance dissipée d'un arc électrique présumé au cours de l'intervalle de temps actif (31) ne dépasse pas une valeur d'énergie maximale admissible prédéterminée $E_{max}$, en particulier une valeur $E_{max}$ = 200 J.

10. Procédé selon l'une quelconque des revendications précédentes, dans lequel la source DC (2) comporte un string (43) et la charge DC (3) comporte un transducteur DC/AC (41) monophasé, relié en sortie à un réseau à tension alternative, AC (45), et dans lequel l'interruption cyclique du flux de puissance P s'effectue de telle sorte qu'un courant AC $I_{AC}$ (t) circulant par une sortie du transducteur DC/AC (41) passe par zéro pendant la deuxième durée $\Delta t_2$ de l'intervalle de temps inactif (32).

11. Procédé selon l'une quelconque des revendications précédentes, dans lequel plusieurs sources DC (2) sont reliées à la charge DC (3) en parallèle les unes avec les autres, chacune au moyen d'une unité de commutation (10), afin d'alimenter conjointement la charge DC (3) avec leurs flux de puissance P respectifs, le procédé étant mis en oeuvre simultanément pour chacune des sources DC (2) de manière à réduire au minimum le chevauchement temporel des intervalles de temps inactifs (32) des différentes sources DC (2).

12. Montage de circuit (1) destiné à la détection d'un arc électrique (9) dans un circuit DC (6) comprenant :

   - une entrée (7) dotée de deux bornes d'entrée (7.1, 7.2) pour le raccordement d'une source DC (2) et une sortie (8) dotée de deux bornes de sortie (8.1, 8.2) pour le raccordement d'une charge DC (3),
   - une unité de commutation (10) disposée entre l'entrée (7) et la sortie (8), éventuellement associée à une tension de sortie $U_{aus}$ présente à la sortie du montage de circuit (1), et configurée, selon un premier mode de fonctionnement (BM1), de manière à permettre le passage d'un flux de puissance P entre l'entrée (7) et la sortie (8) et, selon un deuxième mode de fonctionnement (BM2), de manière à empêcher le passage d'un flux de puissance P entre l'entrée (7) et la sortie (8),
   - un module de mesure (4) servant à déterminer une tension U présente à l'entrée (7) ou à la sortie (8) et/ou un courant I circulant dans une ligne de connexion (23, 24) allant de l'une des bornes d'entrée (7.1, 7.2) à l'une des bornes de sortie (8.1, 8.2), et
   - une unité de commande (5) pour commander l'unité de commutation (10) et éventuellement le module de mesure (4),

   **caractérisé en ce que**
   l'unité de commande (5), en conjonction avec l'unité de commutation (10) et le module de mesure (4), est conçue et mise en place pour permettre la mise en oeuvre du procédé selon l'une quelconque des revendications qui précèdent.

13. Montage de circuit (1) selon la revendication 12, **caractérisé en ce que** l'unité de commutation (10) comprend un commutateur à semi-conducteur placé dans l'une des lignes de connexion (23, 24), le commutateur à semi-conducteur étant dénué de diode de roue libre, ou le commutateur à semi-conducteur comprenant une diode de roue libre intégrée polarisée en inverse par rapport au sens normal du courant du circuit DC (6).

14. Montage de circuit (1) selon la revendication 12 ou 13, **caractérisé en ce que** le montage de circuit (1) ou l'unité de commutation (10) du montage de circuit (1) est configuré en tant que transducteur DC/DC (21), en particulier en tant que convertisseur élévateur.

15. Onduleur photovoltaïque (40) comprenant : au moins une entrée (43) comportant deux bornes d'entrée (43.1, 43.2) pour le raccordement d'un string (45) en tant que source DC (2) et une sortie (44) pour le raccordement à un réseau à tension alternative, AC (46), un transducteur DC/AC (41) pour la conversion d'une tension continue en une tension alternative et un montage de circuit (1) selon l'une des revendications 12 à 14, dont l'entrée (7) est reliée à au moins une entrée (43) de l'onduleur photovoltaïque (40) et dont la sortie (8) est reliée à une entrée du transducteur DC/AC (41).

16. Onduleur photovoltaïque (40) selon la revendication 15, comportant plusieurs entrées (43) destinées chacune au raccordement d'un string (45) en tant que source DC (2), les entrées (43) étant reliées en parallèle les unes aux autres au moyen d'un transducteur DC/DC (21) à un circuit intermédiaire DC commun (42), et le circuit intermédiaire DC (42) étant relié à une entrée du transducteur DC/AC (41) ainsi qu'à plusieurs montages de circuit (1) selon l'une des revendications 12 à 14, chacune des entrées (43) de l'onduleur photovoltaïque (40) étant reliée à l'entrée (7) du montage de circuit (1) qui lui est affecté, et la sortie (8) de chacun des montages de circuit (1) étant reliée à l'entrée du transducteur DC/AC (42).

17. Onduleur photovoltaïque (40) selon la revendication 16, dans lequel l'unité de commande (5) est en outre configurée pour commander le transducteur DC/AC (41) et les transducteurs DC/DC (21) de l'onduleur photovoltaïque (40) de manière à ce qu'en cours de fonctionnement de l'onduleur photovoltaïque (40), une tension présente dans le circuit intermédiaire DC (42) soit maintenue au-dessus d'une valeur maximale des tensions à vide des différents strings (45).

**Fig. 1**

Fig. 2

Fig. 3

EP 4 090 981 B1

Fig. 4

**IN DER BESCHREIBUNG AUFGEFÜHRTE DOKUMENTE**

**In der Beschreibung aufgeführte Patentdokumente**

- WO 2012116722 A1
- WO 2011017721 A1
- WO 2013171329 A1
- DE 10225259 B3